(19) Europäisches Patentamt
European Patent Office
Office européen des brevets

(11) EP 4 389 419 A1

(12) EUROPEAN PATENT APPLICATION
published in accordance with Art. 153(4) EPC

(43) Date of publication:
**26.06.2024 Bulletin 2024/26**

(21) Application number: **22858222.7**

(22) Date of filing: **15.07.2022**

(51) International Patent Classification (IPC):
***B32B 27/20** (2006.01)* ***B32B 27/34** (2006.01)*

(52) Cooperative Patent Classification (CPC):
**B32B 27/20; B32B 27/34**

(86) International application number:
**PCT/JP2022/027904**

(87) International publication number:
**WO 2023/021899 (23.02.2023 Gazette 2023/08)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **18.08.2021 JP 2021133599**

(71) Applicant: **TOYOBO CO., LTD.**
**Osaka-shi, Osaka 530-0001 (JP)**

(72) Inventors:
- **TOKUDA, Kaya**
  **Otsu-shi, Shiga 520-0292 (JP)**
- **WAKUI, Hiroyuki**
  **Otsu-shi, Shiga 520-0292 (JP)**
- **OKUYAMA, Tetsuo**
  **Otsu-shi, Shiga 520-0292 (JP)**
- **NAKAMURA, Makoto**
  **Otsu-shi, Shiga 520-0292 (JP)**
- **YONEMUSHI, Harumi**
  **Otsu-shi, Shiga 520-0292 (JP)**
- **MIZUGUCHI, Denichirou**
  **Otsu-shi, Shiga 520-0292 (JP)**

(74) Representative: **Vossius & Partner**
**Patentanwälte Rechtsanwälte mbB**
**Siebertstrasse 3**
**81675 München (DE)**

# (54) TRANSPARENT HEAT-RESISTANT LAMINATED FILM

(57) Provided is a transparent heat-resistant laminated film that has a sufficiently smooth surface to be used as a substrate in a flexible device, and that has excellent handling properties and suppressed warping. A transparent heat-resistant laminated film characterized by having an (a) layer, a (b) layer, and a blending layer located at the interface between the (a) layer and the (b) layer, the thickness of the blending layer being 3 μm or greater.
(a) layer: A layer that contains a polyimide composition.
(b) layer: A layer that contains a polyimide composition and that has a higher inorganic filler content than the (a) layer.

EP 4 389 419 A1

**Description**

TECHNICAL FIELD

The present invention relates to a transparent heat-resistant laminated film.

BACKGROUND ART

In recent years, for the purpose of decreasing the weight, size, and thickness and of imparting flexibility to functional elements such as semiconductor elements, MEMS elements, and display elements, technological development for forming these elements on polymer films has been actively carried out. In other words, as materials for substrates of electronic parts such as information and communication equipment (broadcasting equipment, mobile radio, portable communication equipment, and the like), radar, and high-speed information processing equipment, ceramics which exhibit heat resistance and can cope with increases in frequencies (reaching the GHz band) of the signal band of information and communication equipment have been conventionally used. However, ceramics are not flexible and are also hardly thinned and thus have a drawback that the applicable fields are limited, and polymer films have recently been used as substrates. Regarding polymer films as flexible substrates, examples of studies such as Patent Documents 1 and 2 have been reported.

As substrate materials for manufacturing flexible electronic devices, the use of polymer films such as polyimide, aromatic polyamide, polyamideimide, polycarbonate, polyethylene naphthalate, and polyethylene terephthalate is considered. Since such polymer films are manufactured in long roll shapes, it is generally accepted that a roll-to-roll manufacturing line is ideal for the manufacture of flexible devices as well.

Meanwhile, in a large number of conventional electronic devices such as display devices, sensor arrays, touch screens and printed wiring boards, hard and rigid substrates such as glass substrates, semiconductor wafers, or glass fiber reinforced epoxy substrates are used, and the manufacturing equipment is also configured on the premise of using such rigid substrates. Hence, in order to form functional elements in polymer film shapes utilizing the existing infrastructure, a process is used in which the polymer films are bonded to, for example, rigid supports made of inorganic substances such as glass plates, ceramic plates, silicon wafers, and metal plates, desired elements are formed on the laminates, and then the polymer films and desired elements are peeled off from the supports.

However, in the process of forming a desired functional element on a laminate in which a polymer film and a support made of an inorganic substance are bonded to each other, the laminate is often exposed to a high temperature. For example, in the formation of functional elements such as polysilicon and oxide semiconductors, a step performed in a temperature region of about 200°C to 600°C is required. In addition, a temperature of about 200 to 300°C may be applied to the film when a hydrogenated amorphous silicon thin film is fabricated, and heating at about 450°C to 600°C may be required in order to heat and dehydrogenate amorphous silicon and obtain low-temperature polysilicon. Hence, the polymer film composing the laminate is required to exhibit heat resistance, but as a practical matter, polymer films which can withstand practical use in such a high temperature region are limited.

PRIOR ART DOCUMENTS

PATENT DOCUMENTS

Patent Document 1: JP-A-2011-74384
Patent Document 2: WO 2012/118020

SUMMARY OF THE INVENTION

PROBLEMS TO BE SOLVED BY THE INVENTION

In such uses, the surface of heat-resistant films on which functional elements are formed is required to exhibit extremely high smoothness (not having irregularities of several μm). Meanwhile, films exhibiting favorable smoothness exhibits poor slipperiness when wound into a roll shape, and this makes it difficult to secure handling properties. As a method to improve the slipperiness of heat-resistant films, there is a method in which a lubricant such as silica particles is added, but there is a problem that the smoothness of the heat-resistant film surface is impaired as a lubricant is added. As a method to solve this problem, there is a method in which a two-layer laminated film including a layer containing a lubricant and a layer not containing a lubricant is fabricated and the layer not containing a lubricant is used as the surface

for forming a functional element. However, there is a problem that warping of the laminated film occurs by slight differences in physical properties between the front and back surfaces due to the addition of a lubricant.

The present invention has been made in view of the above-described problems. In other words, an object of the present invention is to provide a laminated film that has a sufficiently smooth surface to be used as a substrate for a flexible device as well as exhibits favorable handling properties and suppressed warping.

The present inventors have conducted extensive studies to suppress warping of transparent heat-resistant laminated films. As a result, the present inventors have found out that warping can be suppressed to 700 um or less when the thickness of an intermingled layer between layers is 3 μm or more in a transparent heat-resistant laminated film in which layers containing different amounts of lubricant are laminated, and accomplished the present invention based on this knowledge.

In other words, the present invention is as follows.

[1] A transparent heat-resistant laminated film including a layer (a) and a layer (b), in which

an intermingled layer is present at an interface between the layer (a) and the layer (b), and
a thickness of the intermingled layer is 3 μm or more,
layer (a): a layer that contains a polyimide composition
layer (b): a layer that contains a polyimide composition and has a higher inorganic filler content than the layer (a).

[2] The transparent heat-resistant laminated film according to [1] in which an inorganic filler content in the layer (a) is less than 0.03% by mass.
[3] The transparent heat-resistant laminated film according to [1] or [2], in which an inorganic filler content in the layer (b) is 0.03% by mass or more.
[4] The transparent heat-resistant laminated film according to any one of [1] to [3], in which a thickness of the transparent heat-resistant laminated film is 5 μm or more and 200 μm or less.
[5] The transparent heat-resistant laminated film according to any one of [1] to [4], in which all layers, including the layer (a) and the layer (b), constituting the transparent heat-resistant laminated film contain a polyimide composition.
[6] The transparent heat-resistant laminated film according to any one of [1] to [5], in which the transparent heat-resistant laminated film includes only the layer (a), the intermingled layer, and the layer (b).
[7] A laminate including the transparent heat-resistant laminated film according to any one of [1] to [6] and an inorganic substrate, in which an adhesive is substantially not used and a peel strength between the inorganic substrate and the transparent heat-resistant laminated film after heating at 300°C is 0.3 N/cm or less.
[8] A method for manufacturing a film with electronic device, the method including forming an electronic device on a transparent heat-resistant laminated film of the laminate according to [7] and then peeling off the electronic device-formed transparent heat-resistant laminated film from an inorganic substrate.

EFFECT OF THE INVENTION

According to the present invention, the transparent heat-resistant laminated film exhibits favorable handling properties, and it is easy to provide a film having a smooth surface by a roll-to-roll process. Warping of the obtained transparent heat-resistant laminated film is suppressed, and stress is less likely to be applied to the device after device formation on the surface.

BRIEF DESCRIPTION OF THE DRAWINGS

Fig. 1 is a schematic diagram for explaining a method for applying a silane coupling agent according to the present patent.

MODE FOR CARRYING OUT THE INVENTION

Hereinafter, embodiments of the present invention will be described.

<Transparent heat-resistant laminated film>

In the present specification, the transparent heat-resistant laminated film is a film having a melting point of preferably 250°C or more, more preferably 300°C or more, still more preferably 400°C or more. The transparent heat-resistant laminated film is a film formed from a polymer having a glass transition temperature of preferably 200°C or more, more preferably 320°C or more, still more preferably 350°C or more. Hereinafter, the transparent heat-resistant

laminated film will also be simply referred to as a polymer film in order to avoid complication. In the present specification, the melting point and the glass transition temperature are determined by differential thermal analysis (DSC). In a case where the melting point exceeds 500°C, it may be determined whether the temperature has reached the melting point by visually observing the thermal deformation behavior when the transparent heat-resistant laminated film is heated at this temperature.

As the transparency, it is preferable that the total light transmittance is 75% or more. The total light transmittance is more preferably 80% or more, still more preferably 85% or more, yet still more preferably 87% or more, particularly preferably 88% or more. The upper limit of the total light transmittance of the transparent heat-resistant laminated film is not particularly limited, but is preferably 98% or less, more preferably 97% or less for use as a film with electronic device (hereinafter, also referred to as a flexible electronic device).

Examples of the transparent heat-resistant laminated film (hereinafter, also simply referred to as a polymer film) include films of polyimide-based resins (for example, aromatic polyimide resin and alicyclic polyimide resin) such as polyimide, polyamide-imide, polyetherimide, and fluorinated polyimide; copolymerized polyesters (for example, fully aromatic polyester and semi-aromatic polyester) such as polyethylene, polypropylene, polyethylene terephthalate, polybutylene terephthalate, and polyethylene-2,6-naphthalate; copolymerized (meth)acrylate typified by polymethyl methacrylate; polycarbonate; polyamide; polysulfone; polyether sulfone; polyether ketone; cellulose acetate; cellulose nitrate; aromatic polyamide; polyvinyl chloride; polyphenol; polyarylate; polyacetal; modified polyphenylene ether; polyphenylene sulfide; polyphenylene oxide; polystyrene; polybenzoxazole; polybenzothiazole; polybenzimidazole; cyclic polyolefin; liquid crystal polymer; and the like. Examples of the transparent heat-resistant laminated film also include those obtained by reinforcing these with glass inorganic fillers, glass fibers and the like.

However, since the polymer film is premised on being used in a process involving heat treatment at 250°C or more, those that can actually be adopted among the exemplified polymer films are limited. Among the polymer films, a film obtained using a so-called super engineering plastic is preferable, and more specific examples thereof include an aromatic polyimide film, an alicyclic polyimide film, an aromatic amide film, an aromatic amide-imide film, an amide-imide film, an aromatic benzoxazole film, an aromatic benzothiazole film, an aromatic benzimidazole film, a cyclic polyolefin, and a liquid crystal polymer.

The details of the polyimide-based resin films (referred to as polyimide films in some cases) which are an example of the polymer film will be described below. Generally, the polyimide-based resin film is obtained by applying a polyamic acid (polyimide precursor) solution which is obtained by a reaction between a diamine and a tetracarboxylic acid in a solvent, to a support for polyimide film fabrication, drying the solution to form a green film (hereinafter also referred to as "precursor film" or "polyamic acid film"), and further treating the green film by heat at a high temperature on the support for polyimide film fabrication or in a state of being peeled off from the support to cause a dehydration ring-closure reaction. Here, the green film is a film of polyamic acid that contains a solvent and exhibits self-supporting properties. The solvent content in the green film is not particularly limited as long as self-supporting properties are exhibited, but is preferably 1% by mass or more, more preferably 5% by mass or more, still more preferably 10% by mass or more, yet still more preferably 20% by mass or more, particularly preferably 30% by mass or more. The solvent content in the green film is preferably 80% by mass or less, more preferably 70% by mass or less, still more preferably 60% by mass or less, particularly preferably 50% by mass or less.

For the application of the polyamic acid (polyimide precursor) solution, it is possible to appropriately use, for example, conventionally known solution application means such as spin coating, doctor blade, applicator, comma coater, screen printing method, slit coating, reverse coating, dip coating, curtain coating, and slit die coating. Since the method for forming a film by applying a polyamic acid solution has a wide range of material choices, the method is easily considered in order to find a material preferable for easy peeling off, but on the other hand, it is required to control the imidization reaction in the method. In contrast, film formation that does not involve an imidization reaction has an advantage that film formation is easy, and it is thus required to use the methods properly.

The polyimide film in the present invention is a polymer film having an imide bond in the main chain, and is preferably a polyimide film and a polyamide-imide film, more preferably a polyimide film. A polyamide film is also preferable.

Generally, a polyimide film is obtained by applying a polyamic acid (polyimide precursor) solution obtained by a reaction between a diamine and a tetracarboxylic acid in a solvent to a support for polyimide film fabrication, drying the solution to form a green film, and further treating the green film by heat at a high temperature on the support for polyimide film fabrication or in a state of being peeled off from the support to cause a dehydration ring-closure reaction as described above. As another method, a polyimide film is also obtained by applying a polyimide solution obtained by a dehydration ring-closure reaction between a diamine and a tetracarboxylic acid in a solvent to a support for polyimide film fabrication, drying the solution to form a polyimide film containing a solvent at, for example, 1% to 50% by mass, and further treating the polyimide film containing a solvent at 1% to 50% by mass at a high temperature on the support for polyimide film fabrication or in a state of being peeled off from the support for drying.

Generally, a polyamide-imide film is obtained by applying a polyamide-imide solution obtained by a reaction

between a diisocyanate and a tricarboxylic in a solvent to a support for polyamide-imide film fabrication, drying the solution to form a polyamide-imide film containing a solvent at, for example, 1% to 50% by mass, and further treating the polyamide-imide film containing a solvent at 1% to 50% by mass at a high temperature on the support for polyamide-imide film fabrication or in a state of being peeled off from the support for drying.

Generally, a polyamide film is obtained by applying a polyamide solution obtained by a reaction between a diamine and a dicarboxylic acid in a solvent to a support for polyamide film fabrication, drying the solution to form a polyamide film containing a solvent at, for example, 1% to 50% by mass, and further treating the polyamide film containing a solvent at 1% to 50% by mass at a high temperature on the support for polyamide film fabrication or in a state of being peeled off from the support for drying.

As the tetracarboxylic acids, tricarboxylic acids, and dicarboxylic acids, it is possible to use aromatic tetracarboxylic acids (including acid anhydrides thereof), aliphatic tetracarboxylic acids (including acid anhydrides thereof), alicyclic tetracarboxylic acids (including acid anhydrides thereof), aromatic tricarboxylic acids (including acid anhydrides thereof), aliphatic tricarboxylic acids (including acid anhydrides thereof), alicyclic tricarboxylic acids (including acid anhydrides thereof), aromatic dicarboxylic acids, aliphatic dicarboxylic acids, alicyclic dicarboxylic acids and the like that are usually used in the polyimide synthesis, polyamide-imide synthesis, and polyamide synthesis. Among these, aromatic tetracarboxylic anhydrides and alicyclic tetracarboxylic anhydrides are preferable, aromatic tetracarboxylic anhydrides are more preferable from the viewpoint of heat resistance, and alicyclic tetracarboxylic acids are more preferable from the viewpoint of light transmittance. In a case where tetracarboxylic acids are acid anhydrides, the acid anhydrides may have one anhydride structure or two anhydride structures in the molecule, but one (dianhydride) having two anhydride structures in the molecule is preferable. Tetracarboxylic acids, tricarboxylic acids, and dicarboxylic acids may be used singly or in combination of two or more kinds thereof.

Examples of the aromatic tetracarboxylic acids for obtaining a highly colorless and transparent polyimide in the present invention include tetracarboxylic acids such as 4,4'-(2,2-hexafluoroisopropyridene)diphthalic acid, 4,4'-oxydiphthalic acid, bis(1,3-dioxo-1,3-dihydro-2-benzofuran-5-carboxylic acid) 1,4-phenylene, bis(1,3-dioxo-1,3-dihydro-2-benzofuran-5-yl)benzene-1,4-dicarboxylate, 4,4'-[4,4'-(3-oxo-1,3-dihydro-2-benzofuran-1,1-diyl) bis(benzene-1,4-diyloxy)]dibenzene-1,2-dicarboxylic acid, 3,3',4,4'-benzophenonetetracarboxylic acid, 4,4'-[(3-oxo-1,3-dihydro-2-benzofuran-1,1-diyl) bis(toluene-2,5-diyloxy)]dibenzene-1,2-dicarboxylic acid, 4,4'-[(3-oxo-1,3-dihydro-2-benzofuran-1,1-diyl) bis(1,4-xylene-2,5-diyloxy)]dibenzene-1,2-dicarboxylic acid, 4,4'-[4,4'-(3-oxo-1,3-dihydro-2-benzofuran-1,1-diyl) bis(4-isopropyltoluene-2,5-diyloxy)]dibenzene-1,2-dicarboxylic acid, 4,4'-[4,4'-(3-oxo-1,3-dihydro-2-benzofuran-1,1-diyl) bis(naphthalene-1,4-diyloxy)]dibenzene-1,2-dicarboxylic acid, 4,4'-[4,4'-(3H-2,1-benzoxathiol-1,1-dioxide-3,3-diyl) bis(benzene-1,4-diyloxy)]dibenzene-1,2-dicarboxylic acid, 4,4'-benzophenone tetracarboxylic acid, 4,4'-[(3H-2,1-benzoxathiol-1,1-dioxide-3,3-diyl) bis(toluene-2,5-diyloxy)]dibenzene-1,2-dicarboxylic acid, 4,4'-[(3H-2,1-benzoxathiol-1,1-dioxide-3,3-diyl) bis(1,4-xylene-2,5-diyloxy)]dibenzene-1,2-dicarboxylic acid, 4,4'-[4,4'-(3H-2,1-benzoxathiol-1,1-dioxide-3,3-diyl) bis(4-isopropyltoluene-2,5-diyloxy)]dibenzene-1,2-dicarboxylic acid, 4,4'-[4,4'-(3H-2,1-benzoxathiol-1,1-dioxide-3,3-diyl) bis(naphthalene-1,4-diyloxy)]dibenzene-1,2-dicarboxylic acid, 3,3',4,4'-benzophenonetetracarboxylic acid, 3,3',4,4'-benzophenonetetracarboxylic acid, 3,3',4,4'-diphenylsulfonetetracarboxylic acid, 3,3',4,4'-biphenyltetracarboxylic acid, 2,3,3',4'-biphenyltetracarboxylic acid, 2,2',3,3'-biphenyltetracarboxylic acid, 2,2'-diphenoxy-4,4',5,5'-biphenyltetracarboxylic acid, pyromellitic acid, 4,4'-[spiro(xanthene-9,9'-fluorene)-2,6-diyl bis(oxycarbonyl)]diphthalic acid, and 4,4'-[spiro(xanthene-9,9'-fluorene)-3,6-diyl bis(oxycarbonyl)] diphthalic acid, and acid anhydrides thereof. Among these, dianhydrides having two acid anhydride structures are suitable, and particularly 4,4'-(2,2-hexafluoroisopropyridene)diphthalic dianhydride and 4,4'-oxydiphthalic dianhydride are preferable. The aromatic tetracarboxylic acids may be used singly or in combination of two or more kinds thereof. For obtaining high heat resistance, the amount of the aromatic tetracarboxylic acids copolymerized is, for example, preferably 50% by mass or more, more preferably 60% by mass or more, still more preferably 70% by mass or more, yet still more preferably 80% by mass or more of the total amount of all the tetracarboxylic acids.

Examples of the alicyclic tetracarboxylic acids include tetracarboxylic acids such as 1,2,3,4-cyclobutanetetracarboxylic acid, 1,2,3,4-cyclopentanetetracarboxylic acid, 1,2,3,4-cyclohexanetetracarboxylic acid, 1,2,4,5-cyclohexanetetracarboxylic acid, 3,3',4,4'-bicyclohexyltetracarboxylic acid, bicyclo[2,2,1]heptane-2,3,5,6-tetracarboxylic acid, bicyclo[2,2,2]octane-2,3,5,6-tetracarboxylic acid, bicyclo[2,2,2]octo-7-ene-2,3,5,6-tetracarboxylic acid, tetrahydroanthracene-2,3,6,7-tetracarboxylic acid, tetradecahydro-1,4:5,8:9,10-trimethanoanthracene-2,3,6,7-tetracarboxylic acid, decahydronaphthalene-2,3,6,7-tetracarboxylic acid, decahydro-1,4:5,8-dimethanonaphthalene-2,3,6,7-tetracarboxylic acid, decahydro-1,4-ethano-5,8-methanonaphthalene-2,3,6,7-tetracarboxylic acid, norbornane-2-spiro-α-cyclopentanone-α'-spiro-2''-norbornane-5,5''',6,6'-tetracarboxylic acid (also known as "norbornane-2-spiro-2'-cyclopentanone-5'-spiro-2''-norbornane-5,5', 6, 6''-tetracarboxylic acid"), methylnorbornane-2-spiro-α-cyclopentanone-α'-spiro-2''-(methylnorbornane)-5,5', 6, 6''-tetracarboxylic acid, norbornane-2-spiro-α-cyclohexanone-α'-spiro-2''-norbornane-5, 5'', 6, 6''-tetracarboxylic acid (also known as "norbornane-2-spiro-2'-cyclohexanone-6'-spiro-2''-norbornane-5,5', 6, 6 ''-tetracarboxylic acid"), methylnorbornane-2-spiro-α-cyclohexanone-α'-spiro-2''-(methylnorbornane)-5,5', 6, 6''-tetracarboxylic acid, norbornane-2-spiro-α-cyclopropanone-α'-spiro-2''-norbornane-5,5'',6,6'-tetracarboxylic acid, norbornane-2-spiro-α-cyclobutanone-α’-spiro-2"-norbornane-5,5",6,6"-tetracarboxylic acid, norbornane-2-spiro-α-cycloheptanone-α’-spiro-2"-norbornane-5,5",6,6"-tetracarboxylic acid, norbornane-2-spiro-α-cyclooctanone-α’-spiro-2"-norbornane-5,5",6,6"-tetracarboxylic acid, norbornane-2-spiro-α-cyclononanone-α’-spiro-2"-norbornane-5,5",6,6"-tetracarboxylic acid, norbornane-2-spiro-α-cyclodecanone-α’-spiro-2"-norbornane-5,5",6,6"-tetracarboxylic acid, norbornane-2-spiro-α-cycloundecanone-α’-spiro-2"-norbornane-5,5’’,6,6’-tetracarboxylic acid, norbornane-2-spiro-α-cyclododecanone-α’-spiro-2"-norbornane-5,5",6,6"-tetracarboxylic acid, norbornane-2-spiro-α-cyclotridecanone-α’-spiro-2"-norbornane-5,5",6,6"-tetracarboxylic acid, norbornane-2-spiro-α-cyclotetradecanone-α’-spiro-2"-norbornane-5,5",6,6"-tetracarboxylic acid, norbornane-2-spiro-α-cyclopentadecanone-α’-spiro-2"-norbornane-5,5",6,6"-tetracarboxylic acid, norbornane-2-spiro-α-(methylcyclopentanone)-α’-spiro-2"-norbornane-5,5",6,6"-tetracarboxylic acid, and norbornane-2-spiro-α-(methylcyclohexanone)-α’-spiro-2"-norbornane-5,5",6,6"-tetracarboxylic acid, and acid anhydrides thereof. Examples thereof also include an acid anhydride group-containing double-decker silsesquioxane derivative having the structure represented by Formula (1). Among these, dianhydrides having two acid anhydride structures are suitable, particularly 1,2,3,4-cyclobutanetetracarboxylic dianhydride, 1,2,3,4-cyclohexanetetracarboxylic dianhydride, and 1,2,4,5-cyclohexanetetracarboxylic dianhydride are preferable, 1,2,3,4-cyclobutanetetracarboxylic dianhydride and 1,2,4,5-cyclohexanetetracarboxylic dianhydride are more preferable, and 1,2,3,4-cyclobutanetetracarboxylic dianhydride is still more preferable. These may be used singly or in combination of two or more kinds thereof. For obtaining high transparency, the amount of the alicyclic tetracarboxylic acids copolymerized is, for example, preferably 50% by mass or more, more preferably 60% by mass or more, still more preferably 70% by mass or more, yet still more preferably 80% by mass or more of the total amount of all the tetracarboxylic acids.

[Formula 1]

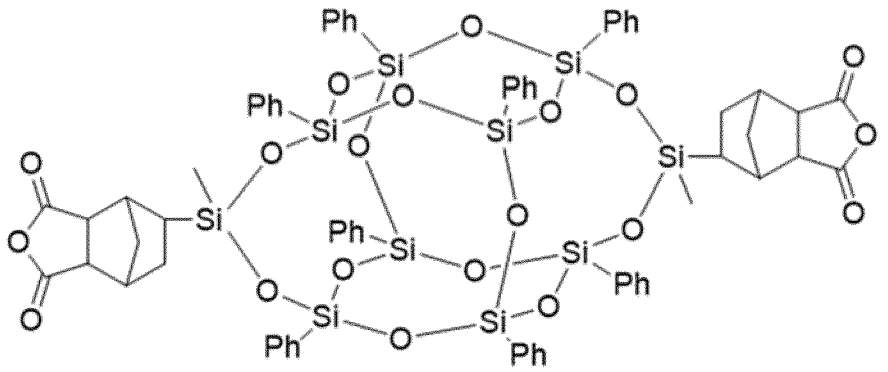

(1)

Examples of the tricarboxylic acids include aromatic tricarboxylic acids such as trimellitic acid, 1,2,5-naphthalenetricarboxylic acid, diphenyl ether-3,3’,4’-tricarboxylic acid, and diphenylsulfone-3,3’,4’-tricarboxylic acid, or hydrogenated products of the aromatic tricarboxylic acids such as hexahydrotrimellitic acid, and alkylene glycol bistrimellitates such as ethylene glycol bistrimellitate, propylene glycol bistrimellitate, 1,4-butanediol bistrimellitate, and polyethylene glycol bistrimellitate and monoanhydrides and esterified products thereof. Among these, monoanhydrides having one acid anhydride structure are suitable, and particularly trimellitic anhydride and hexahydrotrimellitic anhydride are preferable. These may be used singly or a plurality of these may be used in combination.

Examples of the dicarboxylic acids include aromatic dicarboxylic acids such as terephthalic acid, isophthalic acid, orthophthalic acid, naphthalenedicarboxylic acid, and 4,4’-oxydibenzenecarboxylic acid, or hydrogenated products of the aromatic dicarboxylic acids such as 1,6-cyclohexanedicarboxylic acid, and oxalic acid, succinic acid, glutaric acid, adipic acid, heptanedioic acid, octanedioic acid, azelaic acid, sebacic acid, undecanedioic acid, dodecanedioic acid, and 2-methylsuccinic acid and acid chlorides or esterified products thereof. Among these, aromatic dicarboxylic acids and hydrogenated products thereof are suitable, and particularly terephthalic acid, 1,6-cyclohexanedicarboxylic acid, and 4,4’-oxydibenzenecarboxylic acid are preferable. The dicarboxylic acids may be used singly or a plurality of these may be used in combination.

The diamines or isocyanates for obtaining the highly colorless and transparent polyimide in the present invention are not particularly limited, and it is possible to use aromatic diamines, aliphatic diamines, alicyclic diamines, aromatic diisocyanates, aliphatic diisocyanates, alicyclic diisocyanates and the like that are usually used in the polyimide synthesis, polyamide-imide synthesis, and polyamide synthesis. Aromatic diamines are preferable from the viewpoint of heat resistance, and alicyclic diamines are preferable from the viewpoint of transparency. When aromatic diamines having a benzoxazole structure are used, a high elastic modulus, low heat shrinkability, and a low coefficient of linear thermal expansion as well as high heat resistance can be exerted. The diamines and isocyanates may be used singly or in

combination of two or more kinds thereof.

Examples of the aromatic diamines include: 2,2'-dimethyl-4,4'-diaminobiphenyl; 1,4-bis[2-(4-aminophenyl)-2-propyl]benzene; 1,4-bis(4-amino-2-trifluoromethylphenoxy)benzene; 2,2'-ditrifluoromethyl-4,4'-diaminobiphenyl; 4,4'-bis(4-aminophenoxy)biphenyl; 4,4'-bis(3-aminophenoxy)biphenyl; bis[4-(3-aminophenoxy)phenyl]ketone; bis[4-(3-aminophenoxy)phenyl]sulfide; bis[4-(3-aminophenoxy)phenyl] sulfone; 2,2-bis[4-(3-aminophenoxy)phenyl]propane; 2,2-bis[4-(3-aminophenoxy)phenyl]-1,1,1,3,3,3-hexafluoropropane; m-phenylenediamine; o-phenylenediamine; p-phenylenediamine; m-aminobenzylamine; p-aminobenzylamine; 4-amino-N-(4-aminophenyl)benzamide; 3,3'-diaminodiphenylether; 3,4'-diaminodiphenylether; 4,4'-diaminodiphenylether; 2,2'-trifluoromethyl-4,4'-diaminodiphenylether; 3,3'-diaminodiphenylsulfide; 3,4'-diaminodiphenylsulfide; 4,4'-diaminodiphenylsulfide; 3,3'-diaminodiphenylsulfoxide; 3,4'-diaminodiphenylsulfoxide; 4,4'-diaminodiphenylsulfoxide; 3,3'-diaminodiphenyl sulfone; 3,4'-diaminodiphenyl sulfone; 4,4'-diaminodiphenyl sulfone; 3,3'-diaminobenzophenone; 3,4'-diaminobenzophenone; 4,4'-diaminobenzophenone; 3,3'-diaminodiphenylmethane; 3,4'-diaminodiphenylmethane; 4,4'-diaminodiphenylmethane; bis[4-(4-aminophenoxy)phenyl]methane; 1,1-bis[4-(4-aminophenoxy)phenyl]ethane; 1,2-bis[4-(4-aminophenoxy)phenyl]ethane; 1,1-bis[4-(4-aminophenoxy)phenyl]propane; 1,2-bis[4-(4-aminophenoxy)phenyl]propane; 1,3-bis[4-(4-aminophenoxy)phenyl]propane; 2,2-bis[4-(4-aminophenoxy)phenyl]propane; 1,1-bis[4-(4-aminophenoxy)phenyl]butane; 1,3-bis[4-(4-aminophenoxy)phenyl]butane; 1,4-bis[4-(4-aminophenoxy)phenyl]butane; 2,2-bis[4-(4-aminophenoxy)phenyl]butane; 2,3-bis[4-(4-aminophenoxy)phenyl]butane; 2-[4-(4-aminophenoxy)phenyl]-2-[4-(4-aminophenoxy)-3-methylphenyl]propane; 2,2-bis[4-(4-aminophenoxy)-3-methylphenyl]propane; 2-[4-(4-aminophenoxy)phenyl]-2-[4-(4-aminophenoxy)-3,5-dimethylphenyl]propane; 2,2-bis[4-(4-aminophenoxy)-3,5-dimethylphenyl]propane; 2,2-bis[4-(4-aminophenoxy)phenyl]-1,1,1,3,3,3-hexafluoropropane; 1,4-bis(3-aminophenoxy)benzene; 1,3-bis(3-aminophenoxy)benzene; 1,4-bis(4-aminophenoxy)benzene; 4,4'-bis(4-aminophenoxy)biphenyl; bis[4-(4-aminophenoxy)phenyl]ketone; bis[4-(4-aminophenoxy)phenyl]sulfide; bis[4-(4-aminophenoxy)phenyl]sulfoxide; bis[4-(4-aminophenoxy)phenyl] sulfone; bis[4-(3-aminophenoxy)phenyl]ether; bis[4-(4-aminophenoxy)phenyl]ether; 1,3-bis[4-(4-aminophenoxy)benzoyl]benzene; 1,3-bis[4-(3-aminophenoxy)benzoyl]benzene; 1,4-bis[4-(3-aminophenoxy)benzoyl]benzene; 4,4'-bis[(3-aminophenoxy)benzoyl]benzene; 1,1-bis[4-(3-aminophenoxy)phenyl]propane; 1,3-bis[4-(3-aminophenoxy)phenyl]propane; 3,4'-diaminodiphenylsulfide; 2,2-bis[3-(3-aminophenoxy)phenyl]-1,1,1,3,3,3-hexafluoropropane; bis[4-(3-aminophenoxy)phenyl]methane; 1,1-bis[4-(3-aminophenoxy)phenyl]ethane; 1,2-bis[4-(3-aminophenoxy)phenyl]ethane; bis[4-(3-aminophenoxy)phenyl]sulfoxide; 4,4'-bis[3-(4-aminophenoxy)benzoyl]diphenylether; 4,4'-bis[3-(3-aminophenoxy)benzoyl]diphenylether; 4,4'-bis[4-(4-amino-$\alpha$,$\alpha$-dimethylbenzyl)phenoxy]benzophenone; 4,4'-bis[4-(4-amino-$\alpha$,$\alpha$-dimethylbenzyl)phenoxy]diphenyl sulfone; bis[4-{4-(4-aminophenoxy)phenoxy}phenyl] sulfone; 1,4-bis[4-(4-aminophenoxy)phenoxy-$\alpha$,$\alpha$-dimethylbenzyl]benzene; 1,3-bis[4-(4-aminophenoxy)phenoxy-$\alpha$,$\alpha$-dimethylbenzyl]benzene; 1,3-bis[4-(4-amino-6-trifluoromethylphenoxy)-$\alpha$,$\alpha$-dimethylbenzyl]benzene; 1,3-bis[4-(4-amino-6-fluorophenoxy)-$\alpha$,$\alpha$-dimethylbenzyl]benzene; 1,3-bis[4-(4-amino-6-methylphenoxy)-$\alpha$,$\alpha$-dimethylbenzyl]benzene; 1,3-bis[4-(4-amino-6-cyanophenoxy)-$\alpha$,$\alpha$-dimethylbenzyl]benzene; 3,3'-diamino-4,4'-diphenoxybenzophenone; 4,4'-diamino-5,5'-diphenoxybenzophenone; 3,4'-diamino-4,5'-diphenoxybenzophenone; 3,3'-diamino-4-phenoxybenzophenone; 4,4'-diamino-5-phenoxybenzophenone, 3,4'-diamino-4-phenoxybenzophenone; 3,4'-diamino-5'-phenoxybenzophenone; 3,3'-diamino-4,4'-dibiphenoxybenzophenone; 4,4'-diamino-5,5'-dibiphenoxybenzophenone; 3,4'-diamino-4,5'-dibiphenoxybenzophenone; 3,3'-diamino-4-biphenoxybenzophenone; 4,4'-diamino-5-biphenoxybenzophenone; 3,4'-diamino-4-biphenoxybenzophenone; 3,4'-diamino-5'-biphenoxybenzophenone; 1,3-bis(3-amino-4-phenoxybenzoyl)benzene; 1,4-bis(3-amino-4-phenoxybenzoyl)benzene; 1,3-bis(4-amino-5-phenoxybenzoyl)benzene; 1,4-bis(4-amino-5-phenoxybenzoyl)benzene; 1,3-bis(3-amino-4-biphenoxybenzoyl)benzene, 1,4-bis(3-amino-4-biphenoxybenzoyl)benzene; 1,3-bis(4-amino-5-biphenoxybenzoyl)benzene; 1,4-bis(4-amino-5-biphenoxybenzoyl)benzene; 2,6-bis[4-(4-amino-$\alpha$,$\alpha$-dimethylbenzyl)phenoxy]benzonitrile; 4,4'-[9H-fluorene-9,9-diyl]bisaniline (also known as "9,9-bis(4-aminophenyl)fluorene"); spiro(xanthene-9,9'-fluorene)-2,6-diyl bis(oxycarbonyl)]bisaniline; 4,4'-[spiro(xanthene-9,9'-fluorene)-2,6-diyl bis(oxycarbonyl)]bisaniline; 4,4'-[spiro(xanthene-9,9'-fluorene)-3,6-diyl bis(oxycarbonyl)]bisaniline; 9,10-bis(4-aminophenyl)adenine; 2,4-bis(4-aminophenyl)cyclobutane-1,3-dimethyl dicarboxylate; and an amino group-containing double-decker silsesquioxane derivative having the structure represented by Formula (2). A part or all of hydrogen atoms on an aromatic ring of the above-described aromatic diamines may be substituted with halogen atoms; alkyl groups or alkoxyl groups having 1 to 3 carbon atoms; or cyano groups, and further a part or all of hydrogen atoms of the alkyl groups or alkoxyl groups having 1 to 3 carbon atoms may be substituted with halogen atoms. The aromatic diamines having a benzoxazole structure are not particularly limited, and examples thereof include: 5-amino-2-(p-aminophenyl)benzoxazole; 6-amino-2-(p-aminophenyl)benzoxazole; 5-amino-2-(m-aminophenyl)benzoxazole; 6-amino-2-(m-aminophenyl)benzoxazole; 2,2'-p-phenylenebis(5-aminobenzoxazole); 2,2'-p-phenylenebis(6-aminobenzoxazole); 1-(5-aminobenzoxazolo)-4-(6-aminobenzoxazolo)benzene; 2,6-(4,4'-diaminodiphenyl)benzo[1,2-d:5,4-d']bisoxazole; 2,6-(4,4'-diaminodiphenyl)benzo[1,2-d:4,5-d']bisoxazole; 2,6-(3,4'-diaminodiphenyl)benzo[1,2-d:5,4-d']bisoxazole; 2,6-(3,4'-diaminodiphenyl)benzo[1,2-d:4,5-d']bisoxazole; 2,6-(3,3'-diaminodiphenyl)benzo[1,2-d:5,4-d']bisoxazole; and 2,6-(3,3'-diaminodiphenyl)benzo[1,2-d:4,5-d']bisoxazole. Among these, particularly 2,2'-ditrifluoromethyl-4,4'-diaminobiphenyl, 4-amino-N-(4-aminophenyl)benzamide, 4,4'-diaminodiphenyl sulfone, and 3,3'-diaminobenzophenone are

preferable. The aromatic diamines may be used singly or a plurality of these may be used in combination.

[Formula 2]

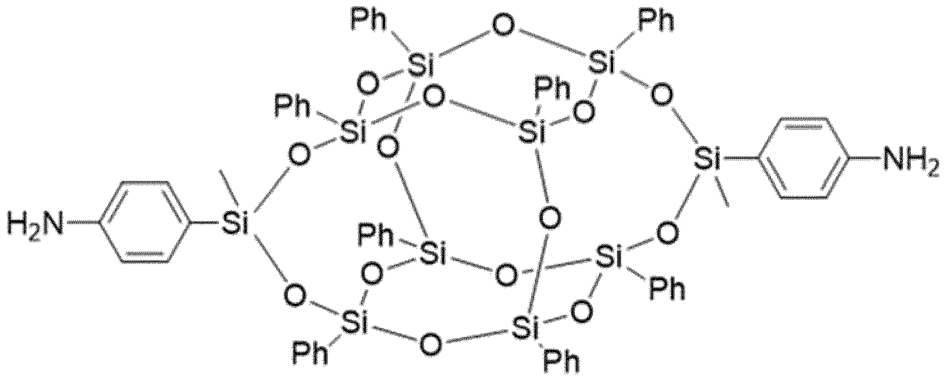

(2)

Examples of the alicyclic diamines include 1,4-diaminocyclohexane, 1,4-diamino-2-methylcyclohexane, 1,4-diamino-2-ethylcyclohexane, 1,4-diamino-2-n-propylcyclohexane, 1,4-diamino-2-isopropylcyclohexane, 1,4-diamino-2-n-butylcyclohexane, 1,4-diamino-2-isobutylcyclohexane, 1,4-diamino-2-sec-butylcyclohexane, 1,4-diamino-2-tert-butylcyclohexane, and 4,4'-methylenebis(2,6-dimethylcyclohexylamine). Among these, particularly 1,4-diaminocyclohexane and 1,4-diamino-2-methylcyclohexane are preferable, and 1,4-diaminocyclohexane is more preferable. The alicyclic diamines may be used singly or a plurality of these may be used in combination.

Examples of the diisocyanates include aromatic diisocyanates such as diphenylmethane-2,4'-diisocyanate, 3,2'- or 3,3'- or 4,2'- or 4,3'- or 5,2'- or 5,3'- or 6,2'- or 6,3'-dimethyldiphenylmethane-2,4'-diisocyanate, 3,2'- or 3,3'- or 4,2'- or 4,3'- or 5,2'- or 5,3'- or 6,2'- or 6,3'-diethyldiphenylmethane-2,4'-diisocyanate, 3,2'- or 3,3'- or 4,2'- or 4,3'- or 5,2'- or 5,3'- or 6,2'- or 6,3'-dimethoxydiphenylmethane-2,4'-diisocyanate, diphenylmethane-4,4'-diisocyanate, diphenylmethane-3,3'-diisocyanate, diphenylmethane-3,4'-diisocyanate, diphenyl ether-4,4'-diisocyanate, benzophenone-4,4'-diisocyanate, diphenylsulfone-4,4'-diisocyanate, tolylene-2,4-diisocyanate, tolylene-2,6-diisocyanate, m-xylylene diisocyanate, p-xylylene diisocyanate, naphthalene-2,6-diisocyanate, 4,4'-(2,2 bis(4-phenoxyphenyl)propane)diisocyanate, 3,3'- or 2,2'-dimethylbiphenyl-4,4'-diisocyanate, 3,3'- or 2,2'-diethylbiphenyl-4,4'-diisocyanate, 3,3'-dimethoxybiphenyl-4,4'-diisocyanate, and 3,3'-diethoxybiphenyl-4,4'-diisocyanate, and hydrogenated diisocyanates of any of these (for example, isophorone diisocyanate, 1,4-cyclohexane diisocyanate, 1,3-cyclohexane diisocyanate, 4,4'-dicyclohexylmethane diisocyanate, and hexamethylene diisocyanate). Among these, diphenylmethane-4,4'-diisocyanate, tolylene-2,4-diisocyanate, tolylene-2,6-diisocyanate, 3,3'-dimethylbiphenyl-4,4'-diisocyanate, naphthalene-2,6-diisocyanate, 4,4'-dicyclohexylmethane diisocyanate, and 1,4-cyclohexane diisocyanate are preferable from the viewpoint of low moisture absorption property, dimensional stability, price, and polymerizability. The diisocyanates may be used singly or a plurality of these may be used in combination.

The transparent heat-resistant laminated film of the present invention has a layer (a) and a layer (b). In other words, the transparent heat-resistant laminated film is a film in which at least two layers, the layer (a) and the layer (b), are laminated. The layer (a) is a layer that contains a polyimide composition, and the layer (b) is a layer that contains a polyimide composition and has a higher inorganic filler content than the layer (a). The inorganic filler content in the layer (a) is not particularly limited, but is preferably less than 0.03% by mass, more preferably less than 0.02% by mass, still more preferably less than 0.01% by mass, and may be 0% by mass. In a case where the inorganic filler content in the layer (a) is 0% by mass, the layer (a) may be a layer composed only of the polyimide. The inorganic filler content in the layer (b) is not particularly limited as long as it is higher than that in the layer (a), but is preferably 0.03% by mass or more, more preferably 0.05% by mass or more, still more preferably 0.08% by mass or more, yet still more preferably 0.1% by mass or more. The upper limit is not particularly limited, but is preferably 3% by mass or less, more preferably 1% by mass or less, still more preferably 0.5% by mass or less. By adjusting the inorganic filler contents in the layer (a) and the layer (b) to be in the above ranges, high slipperiness of the transparent heat-resistant laminated film surface can be maintained without impairing the transparency of the transparent heat-resistant laminated film.

In the transparent heat-resistant laminated film, by adding a more amount of inorganic filler to the surface (the layer (b)) opposite to the surface (the layer (a)) where a functional element is formed or by adding the inorganic filler only to the layer (b), it is possible to obtain a long transparent heat-resistant laminated film that can be wound up into a long roll without wrinkling while securing the smoothness of the layer (a) surface.

Examples of the inorganic filler include silica, carbon, and ceramic, and silica is preferable among these. These

inorganic fillers may be used singly or two or more kinds thereof may be used concurrently. By adding an inorganic filler, protrusions are imparted to the transparent heat-resistant laminated film surface, and this increases the slipperiness of the transparent heat-resistant laminated film surface. By adding an inorganic filler, the CTE and Rth of the transparent heat-resistant laminated film can be suppressed to low levels. The average particle size of inorganic filler is preferably 1 nm or more, more preferably 5 nm or more, still more preferably 10 nm or more, particularly preferably 30 nm or more. The average particle size of inorganic filler is preferably 1 μm or less, more preferably 500 nm or less, still more preferably 100 nm or less.

The method for adding an inorganic filler to the transparent heat-resistant laminated film is not particularly limited, but examples thereof include a method in which the filler is added as a powder and a method in which the filler is added in the form of filler/solvent (slurry) when or after the above-mentioned polyamic acid (polyimide precursor) solution, polyimide solution, polyamide-imide solution, or polyamide solution is prepared, and the method in which the filler is added as a slurry is particularly preferable among others. The slurry is not particularly limited, but examples thereof include a slurry in which silica having an average particle size of 10 nm is dispersed in N,N-dimethylacetamide (DMAC) at a concentration of 20% by mass (for example, "SNOWTEX (registered trademark) DMAC-ST" manufactured by Nissan Chemical Corporation) and a slurry in which silica having an average particle size of 80 nm is dispersed in N,N-dimethylacetamide (DMAC) at a concentration of 20% by mass (for example, "SNOWTEX (registered trademark) DMAC-ST-ZL" manufactured by Nissan Chemical Corporation).

The transparent heat-resistant laminated film of the present invention may have a two-layer configuration consisting only of the layer (a) and the layer (b), or may have a laminated configuration of three or more layers. It is preferable that all layers, including the layer (a) and the layer (b), constituting the transparent heat-resistant laminated film contain a polyimide composition. In the present specification, the physical properties (yellowness index, total light transmittance, haze, and the like) of the transparent heat-resistant laminated film refer to the values for the entire transparent heat-resistant laminated film unless otherwise stated.

The yellowness index (hereafter, also referred to as "yellow index" or "YI") of the transparent heat-resistant laminated film in the present invention is preferably 10 or less, more preferably 7 or less, still more preferably 5 or less, yet still more preferably 3 or less. The lower limit of the yellowness index of the transparent heat-resistant laminated film is not particularly limited, but is preferably 0.1 or more, more preferably 0.2 or more, still more preferably 0.3 or more for use as a flexible electronic device.

The light transmittance of the transparent heat-resistant laminated film at a wavelength of 400 nm in the present invention is preferably 70% or more, more preferably 72% or more, still more preferably 75% or more, yet still more preferably 80% or more. The upper limit of the light transmittance of the transparent heat-resistant film at a wavelength of 400 nm is not particularly limited, but is preferably 99% or less, more preferably 98% or less, still more preferably 97% or less for use as a flexible electronic device.

The total light transmittance of the transparent heat-resistant laminated film in the present invention is preferably 75% or more, more preferably 85% or more, still more preferably 87% or more, yet still more preferably 88% or more. The upper limit of the total light transmittance of the transparent heat-resistant laminated film is not particularly limited, but is preferably 98% or less, more preferably 97% or less for use as a flexible electronic device.

The haze of the transparent heat-resistant laminated film in the present invention is preferably 2.0 or less, more preferably 1.5 or less, still more preferably 1.0 or less, yet still more preferably 0.8 or less, even yet still more preferably 0.5 or less, far even yet still more preferably 0.3 or less.

The out of plane retardation (Rth) of the transparent heat-resistant laminated film in the present invention is preferably 500 nm or less, more preferably 300 nm or less, still more preferably 200 nm or less, yet still more preferably 100 nm or less. The lower limit of Rth of the transparent heat-resistant laminated film is not particularly limited, but is preferably 0.1 nm or more, more preferably 0.5 nm or more for use as a flexible electronic device.

The thickness of the transparent heat-resistant laminated film in the present invention is preferably 5 μm or more, more preferably 8 μm or more, still more preferably 15 μm or more, yet still more preferably 20 μm or more. The upper limit of the thickness of the transparent heat-resistant laminated film is not particularly limited but is preferably 200 μm or less, more preferably 150 μm or less, still more preferably 90 um or less for use as a flexible electronic device. It may be difficult to fabricate and transport the film when the thickness is too thin and it may be difficult to transport the roll when the thickness is too thick.

The highly colorless and transparent polyimide film having the coefficient of linear thermal expansion (CTE) of the present invention can be realized by performing stretching in the course of forming the polyimide film. Such stretching operation can be realized by performing stretching by 1.5-fold to 4.0-fold in the MD direction and 1.4-fold to 3.0-fold in the TD direction in the course of applying a polyimide solution to a support for polyimide film fabrication, drying the solution to form a polyimide film containing a solvent at 1% to 50% by mass, and further treating the polyimide film containing a solvent at 1% to 50% by mass at a high temperature on the support for polyimide film fabrication or in a state of being peeled off from the support for drying. At this time, by stretching the thermoplastic polymer film and the polyimide film at the same time using an unstretched thermoplastic polymer film as the support for polyimide film fabrication

and then peeling off the stretched polyimide film from the thermoplastic polymer film, it is possible to prevent the polyimide film from being scratched at the time of stretching in the MD direction and to obtain a highly colorless and transparent polyimide film with higher quality.

The average coefficient of linear thermal expansion (CTE) of the transparent heat-resistant laminated film at between 30°C and 300°C is preferably 50 ppm/K or less. The CTE is more preferably 45 ppm/K or less, still more preferably 40 ppm/K or less, yet still more preferably 30 ppm/K or less, particularly preferably 20 ppm/K or less. The CTE is preferably -5 ppm/K or more, more preferably -3 ppm/K or more, still more preferably 1 ppm/K or more. When the CTE is in the above range, a small difference in coefficient of linear thermal expansion between the transparent heat-resistant laminated film and a general support (inorganic substrate) can be maintained, and the transparent heat-resistant laminated film and the inorganic substrate can be prevented from peeling off from each other or warping together with the support when being subjected to a process in which heat is applied as well. Here, CTE is a factor that represents reversible expansion and contraction with respect to the temperature. The CTE of the transparent heat-resistant laminated film refers to the average value of the CTE in the machine direction (MD direction) and the CTE in the transverse direction (TD direction) of the transparent heat-resistant laminated film. The method for measuring the CTE of the transparent heat-resistant laminated film is as described in Examples.

The transparent heat-resistant laminated film of the present invention includes an intermingled layer at the lamination interface between the layer (a) and the layer (b), and the thickness of the intermingled layer is 3 um or more. In the transparent heat-resistant laminated film, differences in individual CTE between the respective layers may cause warping, but when there is a sufficient intermingled layer at the interface between the layer (a) and the layer (b), warping can be suppressed compared to the case where there is no intermingled layer. The thickness of the intermingled layer is preferably 5 μm or more, more preferably 6 μm or more. When the intermingled layer is 3 μm or more, the warping of the transparent heat-resistant laminated film can be suppressed to 700 μm or less. The upper limit of the intermingled layer is not particularly limited as long as it is less than the sum of the thickness of one layer (a) and the thickness of one layer (b) and the smoothness on the layer (a) surface side and the slipperiness on the layer (b) surface side are not impaired, but is preferably 90% or less, more preferably 80% or less, still more preferably 70% or less of the sum of the thickness of one layer (a) and the thickness of one layer (b). The intermingled layer refers to a transition layer in which the chemical composition contained in the layer (a) and the chemical composition contained in the layer (b) change with a gradient. In a case where the thickness of the intermingled layer is not constant, the value at the place where the intermingled layer is the thickest (largest) is taken as the thickness.

The means for forming an intermingled layer having a thickness of 3 μm or more includes a method in which two layers, the layer (a) and the layer (b), are applied simultaneously or sequentially (hereinafter, also referred to as "simultaneous/sequential application") and integrated by solution film formation while diffusing the solutions to fabricate a film. In this case, in order to diffuse the solutions, it is desirable to perform heating (drying) in a certain period of time after simultaneous/sequential application, and the time is preferably 30 seconds or more, more preferably 60 seconds or more, still more preferably 90 seconds or more, yet still more preferably 120 seconds or more. Meanwhile, when the first layer is heated (dried) and then the next layer (second layer) is fabricated (applied), the thickness of intermingled layers is smaller as compared with that in the case of simultaneous/sequential application whether in the middle of the heating step or after the completion of the heating step. However, in a case in the middle of heating (drying) as well, for example, when the time for the solvent to diffuse is waited in a state where a solution containing a large amount of solvent is applied to the second layer, the thickness of intermingled layers is smaller than in the case of simultaneous/sequential application in many cases, but intermingling itself is promoted. However, in a case in the middle of heating (drying) as well, for example, when a solvent is applied onto the second layer and diffusion of the solvent is promoted, the thickness of intermingled layers is smaller than in the case of simultaneous/sequential application in many cases, but intermingling itself is promoted.

As a combination of the layer (a) and the layer (b), one may be polyimide formed from a polyamic acid solution and the other may be polyimide formed from soluble polyimide. In a case where both the layer (a) and the layer (b) are formed of soluble polyimide, it is possible to form an intermingled layer by simultaneous or sequential application, but it is preferable to form one layer from polyamic acid from the viewpoint of suppressing warping since the intermingled layer becomes thicker. Furthermore, it is more preferable that both the layer (a) and the layer (b) are polyimide formed from a polyamic acid solution since intermingling is promoted.

It is also possible to fabricate a film having a variety of properties by fabricating a film having a configuration of two or more layers from materials (resins) having different physical properties, and it is conceivable to impart features to the spectral characteristics by forming any one of the layers as a layer that absorbs ultraviolet rays or infrared rays, and to control the incidence and emission of light by layers having different refractive indexes.

The heat shrinkage rate of the transparent heat-resistant laminated film at between 30°C and 500°C is preferably ± 0.9%, still more preferably ± 0.6%. The heat shrinkage rate is a factor that represents irreversible expansion and contraction with respect to the temperature.

The tensile strength at break of the transparent heat-resistant laminated film is preferably 60 MPa or more,

more preferably 120 MPa or more, still more preferably 240 MPa or more. The upper limit of the tensile strength at break is not particularly limited but is practically less than about 1000 MPa. When the tensile strength at break is 60 MPa or more, it is possible to prevent the transparent heat-resistant laminated film from breaking when being peeled off from the inorganic substrate. The tensile strength at break of the transparent heat-resistant laminated film refers to the average value of the tensile strength at break in the machine direction (MD direction) and the tensile strength at break in the transverse direction (TD direction) of the transparent heat-resistant laminated film. The method for measuring the tensile strength at break of the transparent heat-resistant laminated film is as described in Examples. When the transparent heat-resistant laminated film is fabricated after application onto a glass substrate has been performed using a casting applicator as well, orthogonal two directions of the parallel direction and vertical direction to the application using a casting applicator are defined as (MD direction) and (TD direction), respectively. Hereinafter, the same applies to the tensile elongation at break and the tensile modulus as well.

The tensile elongation at break of the transparent heat-resistant laminated film is preferably 1% or more, more preferably 5% or more, still more preferably 20% or more. When the tensile elongation at break is 1% or more, the handleability is excellent. The tensile elongation at break of the transparent heat-resistant laminated film refers to the average value of the tensile elongation at break in the machine direction (MD direction) and the tensile elongation at break in the transverse direction (TD direction) of the transparent heat-resistant laminated film. The method for measuring the tensile elongation at break of the transparent heat-resistant laminated film is as described in Examples.

The tensile modulus of the transparent heat-resistant laminated film is preferably 2 GPa or more, more preferably 3 GPa or more, still more preferably 4 GPa or more. When the tensile modulus is 3 GPa or more, the transparent heat-resistant laminated film is less expanded and deformed when being peeled off from the inorganic substrate and exhibits excellent handleability. The tensile modulus is preferably 20 GPa or less, more preferably 12 GPa or less, still more preferably 10 GPa or less. When the tensile modulus is 20 GPa or less, the transparent heat-resistant laminated film can be used as a flexible film. The tensile modulus of the transparent heat-resistant laminated film refers to the average value of the tensile modulus in the machine direction (MD direction) and the tensile modulus in the transverse direction (TD direction) of the transparent heat-resistant laminated film. The method for measuring the tensile modulus of the transparent heat-resistant laminated film is as described in Examples.

The thickness unevenness of the transparent heat-resistant laminated film is preferably 20% or less, more preferably 12% or less, still more preferably 7% or less, particularly preferably 4% or less. When the thickness unevenness exceeds 20%, it tends to be difficult to apply the film to narrow portions. The thickness unevenness of the transparent heat-resistant laminated film can be determined, for example, based on the following equation from the film thicknesses, which are measured at about 10 randomly extracted locations of the film to be measured using a contact-type film thickness meter.

$$\text{Film thickness unevenness (\%)} = 100 \times (\text{maximum film thickness - minimum film thickness}) \div \text{average film thickness}$$

The transparent heat-resistant laminated film is preferably obtained in the form of being wound as a long transparent heat-resistant laminated film having a width of 300 mm or more and a length of 10 m or more at the time of production, more preferably in the form of a roll-shaped transparent heat-resistant laminated film wound around a winding core. When the transparent heat-resistant laminated film is wound in a roll shape, it is easy to transport the transparent heat-resistant laminated film in the form of a film wound in a roll shape.

As a means for fabricating a film having a layer configuration of two or more layers, various methods such as simultaneous application using a T-die capable of simultaneously discharging two layers, sequential application in which one layer is applied and then the next layer is applied, a method in which one layer is applied and then dried and then the next layer is applied, a method in which the next layer is applied after the film formation of one layer has been finished, or multilayering by heat lamination using a thermoplastic layer inserted between layers are conceivable. However, in the present patent, simultaneous application using a T-die capable of simultaneously discharging two layers and sequential application in which one layer is applied and then the next layer is applied are particularly preferable in order to form an intermingled layer having a thickness of 3um or more.

The thickness of the layer (a) is preferably 1 μm or more. The thickness of the layer (a) is more preferably 3 μm or more, still more preferably 5 μm or more, yet still more preferably 10 um or more. The thickness of the layer (a) is preferably 30 μm or less, more preferably 28 μm or less from the viewpoint thinning the entire transparent heat-resistant laminated film. The thickness of the layer (a) does not include the thickness of the intermingled layer. In a case where the thickness of the layer (a) is not constant, the value at the place where the thickness of the intermingled layer present at the interface with the layer (a) is the thickest (largest) is taken as the thickness. In other words, the thinnest (smallest) value of the thickness of the layer (a) is taken as the thickness.

The thickness of the layer (b) is preferably 0.1 μm or more, more preferably 0.4 um or more. The thickness of the layer (b) is preferably 5 μm or less, more preferably 2 μm or less, still more preferably 1 μm or less from the viewpoint

of thinning the entire transparent heat-resistant laminated film. The thickness of the layer (b) does not include the thickness of the intermingled layer. In a case where the thickness of the layer (b) is not constant, the value at the place where the thickness of the intermingled layer present at the interface with the layer (b) is the thickest (largest) is taken as the thickness. Specifically, the thickness at the place where the thicknesses of the layer (a) and the intermingled layer are measured is taken as the thickness of the layer (b). In other words, the film thickness of the entire transparent heat-resistant laminated film including the layer (a) and the layer (b) is the total value of the thicknesses of the layer (a), the layer (b), and the intermingled layer.

The warping of the transparent heat-resistant laminated film is preferably 700 μm or less. The warping is more preferably 600 μm or less. By suppressing the warping of the transparent heat-resistant laminated film to 700 μm or less, stress due to film warping can be suppressed from being applied to the device when a device is formed on the transparent heat-resistant laminated film and the device-formed transparent heat-resistant laminated film is peeled off from the inorganic substrate in a laminate of the transparent heat-resistant laminated film and an inorganic substrate. The method for measuring warping of the transparent heat-resistant laminated film is as described in Examples.

<Inorganic substrate>

The inorganic substrate may be a plate-type substrate which can be used as a substrate made of an inorganic substance, and examples thereof include those mainly composed of glass plates, ceramic plates, semiconductor wafers, metals and the like and those in which these glass plates, ceramic plates, semiconductor wafers, and metals are laminated, those in which these are dispersed, and those in which fibers of these are contained as the composite of these.

Examples of the glass plates include quartz glass, high silicate glass (96% silica), soda lime glass, lead glass, aluminoborosilicate glass, and borosilicate glass (Pyrex (registered trademark)), borosilicate glass (alkali-free), borosilicate glass (microsheet), aluminosilicate glass and the like. Among these, those having a coefficient of linear thermal expansion of 5 ppm/K or less are desirable, and in the case of a commercially available product, "Corning (registered trademark) 7059", "Corning (registered trademark) 1737", and "EAGLE" manufactured by Corning Inc., "AN100" manufactured by AGC Inc., "OA10" and "OA11G" manufactured by Nippon Electric Glass Co., Ltd., "AF32" manufactured by SCHOTT AG, and the like that are glass for liquid crystal are desirable.

The semiconductor wafer is not particularly limited, but examples thereof include a silicon wafer and wafers of germanium, silicon-germanium, gallium-arsenide, aluminum-gallium-indium, nitrogen-phosphorus-arsenic-antimony, SiC, InP (indium phosphide), InGaAs, GaInNAs, LT, LN, ZnO (zinc oxide), CdTe (cadmium telluride), ZnSe (zinc selenide) and the like. Among these, the wafer preferably used is a silicon wafer, and a mirror-polished silicon wafer having a size of 8 inches or more is particularly preferable.

The metals include single element metals such as W, Mo, Pt, Fe, Ni, and Au, alloys such as Inconel, Monel, Nimonic, carbon-copper, Fe-Ni-based Invar alloy, and Super Invar alloy, and the like. Multilayer metal plates formed by adding another metal layer or a ceramic layer to these metals are also included. In this case, when the overall coefficient of linear thermal expansion (CTE) with the additional layer is low, Cu, Al and the like are also used in the main metal layer. The metals used as the addition metal layer is not limited as long as they are those that strengthen the close contact property with the highly heat-resistant film, those that exhibit properties such as no diffusion and favorable chemical resistance and heat resistance, but suitable examples thereof include Cr, Ni, TiN, and Mo-containing Cu.

Examples of the ceramic plate in the present invention include ceramics for substrate such as $Al_2O_3$, mullite, ALN, SiC, crystallized glass, cordierite, spodumene, Pb-BSG+$CaZrO_3$+$Al_2O_3$, crystallized glass+$Al_2O_3$, crystallized Ca-BSG, BSG+quartz, BSG+$Al_2O_3$, Pb-BSG+$Al_2O_3$, glass-ceramic, and zerodur material.

It is desirable that the planar portion of the inorganic substrate is sufficiently flat. Specifically, the P-V value of the surface roughness is 50 nm or less, more preferably 20 nm or less, still more preferably 5 nm or less. When the surface is coarser than this, the peel strength between the transparent heat-resistant laminated film layer and the inorganic substrate may be insufficient.

The thickness of the inorganic substrate is not particularly limited, but a thickness of 10 mm or less is preferable, a thickness of 3 mm or less is more preferable, and a thickness of 1.3 mm or less is still more preferable from the viewpoint of handleability. The lower limit of the thickness is not particularly limited, but is preferably 0.07 mm or more, more preferably 0.15 mm or more, still more preferably 0.3 mm or more. When the inorganic substrate is too thin, the inorganic substrate is easily destroyed and it is difficult to handle the inorganic substrate. When the inorganic substrate is too thick, the inorganic substrate is heavy and it is difficult to handle the inorganic substrate.

<Laminate>

The laminate of the present invention is obtained by laminating the transparent heat-resistant laminated film and the inorganic substrate substantially without using an adhesive. Since a smooth surface is required to form a device, the lamination surface with the inorganic substrate is preferably on the layer (b) side. In the thickness direction of the

laminate, the laminate may have a configuration in which both ends are the inorganic substrate (for example, inorganic substrate/transparent heat-resistant laminated film/inorganic substrate). In this case, an adhesive is substantially not used for the transparent heat-resistant laminated film and the inorganic substrate at both ends.

The shape of the layered body is not particularly limited and may be square or rectangular. The shape of the laminate is preferably rectangular, and the length of the long side is preferably 300 mm or more, more preferably 500 mm or more, still more preferably 1000 mm or more. The upper limit is not particularly limited, but it is desirable that the laminate replaces a substrate, which has an industrially used size and is formed from an industrially used material. A length of 20000 mm or less is sufficient, and the length of the long side may be 10000 mm or less.

<Adhesive>

An adhesive layer is substantially not interposed between the inorganic substrate and the transparent heat-resistant laminated film of the present invention. Here, the adhesive layer in the present invention refers to a layer containing a Si (silicon) component at less than 10% as a mass ratio (less than 10% by mass). Substantially not used (not interposed) means that the thickness of the adhesive layer interposed between the inorganic substrate and the transparent heat-resistant laminated film is preferably 0.4 μm or less, more preferably 0.1 μm or less, still more preferably 0.05 μm or less, particularly preferably 0.03 μm or less, most preferably 0 μm.

<Silane coupling agent (SCA)>

In the laminate, it is preferable to have a layer of a silane coupling agent between the transparent heat-resistant laminated film and the inorganic substrate. In the present invention, the silane coupling agent refers to a compound containing a Si (silicon) component at 10% by mass or more. Further, it is preferable to have an alkoxy group in the structure. It is desirable not to contain a methyl group in the structure. By using the silane coupling agent layer, the intermediate layer between the transparent heat-resistant laminated film and the inorganic substrate can be thinned, and thus there are effects that the amount of degassed components during heating is small, elution hardly occurs in the wet process as well, and only a trace amount of components is eluted even if elution occurs. The silane coupling agent preferably contains a large amount of silicon oxide component since the heat resistance is improved, and is particularly preferably one exhibiting heat resistance at a temperature of about 400°C. The thickness of the silane coupling agent layer is preferably less than 0.2 um. As a range for use as a flexible electronic device, the thickness of the silane coupling agent layer is preferably 100 nm or less (0.1 um or less), more desirably 50 nm or less, still more desirably 10 nm. When a silane coupling agent layer is normally fabricated, the thickness thereof is about 0.10 um or less. In processes where it is desired to use as little silane coupling agent as possible, a silane coupling agent layer having a thickness of 5 nm or less can also be used. There is the possibility that the peel strength decreases or some parts are not be attached when the thickness is 1 nm or less, and it is thus desirable that the thickness of the silane coupling agent layer is 1 nm or more.

The silane coupling agent in the present invention is not particularly limited, but one having an amino group or an epoxy group is preferable. Specific examples of the silane coupling agent include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl N-(1,3-dimethyl-butylidene)propylamine, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilanevinyltrichlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-phenyl-3-aminopropyltrimethoxysilane, N-(vinylbenzyl)-2-aminoethyl-3-aminopropyltrimethoxysilane hydrochloride, 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl)tetrasulfide, 3-isocyanatepropyltriethoxysilane, tris-(3-trimethoxysilylpropyl)isocyanurate, chloromethylphenetyltrimethoxysilane, and chloromethyltrimethoxysilane. Among these, preferred examples include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, aminophenyltrimethoxysilane, aminophenetyltrimethoxysilane, and aminophenylaminomethylphenetyltrimethoxysilane. When heat resistance is required in the process, a silane coupling agent, in which Si and an amino group or the like is linked to each other via an aromatic, is desirable.

In the laminate, the peel strength between the transparent heat-resistant laminated film and the inorganic substrate after heating at 300°C is preferably 0.3 N/cm or less. This makes it remarkably easy to peel off the transparent

heat-resistant laminated film from the inorganic substrate after a device is formed on the transparent heat-resistant laminated film. Hence, it is possible to manufacture a device connected body that can be produced in a large quantity and it is easy to manufacture a flexible electronic device. The peel strength is preferably 0.25 N/cm or less, more preferably 0.2 N/cm or less, still more preferably 0.15 N/cm or less, particularly preferably 0.12 N/cm or less. The peel strength is preferably 0.03 N/cm or more. The peel strength is more preferably 0.06 N/cm or more, still more preferably 0.08 N/cm or more, particularly preferably 0.1 N/cm or more since the laminate does not peel off when a device is formed on the transparent heat-resistant laminated film. The peel strength is the peel strength between the transparent heat-resistant laminated film and the inorganic substrate in the laminate after the transparent heat-resistant laminated film and the inorganic substrate are bonded together and then subjected to heat treatment at 300°C for 1 hour in a nitrogen atmosphere.

The laminate of the present invention can be fabricated, for example, according to the following procedure. The laminate can be obtained by treating at least one surface of the inorganic substrate with a silane coupling agent in advance, superimposing the surface treated with a silane coupling agent on the transparent heat-resistant film, and pressurizing the two for lamination. The laminate can also be obtained by treating at least one surface of the transparent heat-resistant laminated film with a silane coupling agent in advance, superimposing the surface treated with a silane coupling agent on the inorganic substrate, and pressurizing the two for lamination. It is preferable that the layer (b) surface of the transparent heat-resistant laminated film is superimposed on the inorganic substrate. Examples of the pressurization method include normal pressing or lamination in the atmosphere or pressing or lamination in a vacuum. Lamination in the atmosphere is desirable in the case of a laminate having a large size (for example, more than 200 mm) in order to obtain a stable peel strength over the entire surface. In contrast, pressing in a vacuum is preferable in the case of a laminate having a small size of about 200 mm or less. As the degree of vacuum, a degree of vacuum obtained by an ordinary oil-sealed rotary pump is sufficient, and about 10 Torr or less is sufficient. The pressure is preferably 1 MPa to 20 MPa, still more preferably 3 MPa to 10 MPa. The substrate may be destroyed when the pressure is high, and close contact may not be achieved at some portions when the pressure is low. The temperature is preferably 90°C to 300°C, still more preferably 100°C to 250°C. The film may be damaged when the temperature is high, and the close contact force may be weak when the temperature is low.

<Fabrication of film with electronic device (flexible electronic device)>

When the laminate is used, a flexible electronic device can be easily fabricated by using existing equipment and processes for electronic device manufacture. Specifically, a flexible electronic device can be fabricated by forming an electronic device on the transparent heat-resistant laminated film of the laminate and peeling off the electronic device together with the transparent heat-resistant laminated film from the laminate.

In the present specification, the electronic device refers to a wiring board which carries out electrical wiring and has a single-sided, double-sided, or multilayered structure, electronic circuits including active devices such as transistors and diodes and passive devices such as resistors, capacitors, and inductors, sensor elements which sense pressure, temperature, light, humidity and the like, biosensor elements, light emitting elements, image display elements such as liquid crystal displays, electrophoresis displays, and self-luminous displays, wireless and wired communication elements, arithmetic elements, storage elements, MEMS elements, solar cells, thin film transistors, and the like.

The electronic device also includes an interposer function, which is an electrode that penetrates the polyimide in this wiring board. By roughly penetrating the electrode, the step of fabricating a through electrode after the inorganic substrate has been peeled off is largely omitted. A known method may be used to fabricate a through hole. For example, for rough penetration, a through hole is drilled using a UV nanolaser. Next, for example, there is a method in which the through hole is filled with a conductive metal by applying the conventional method used for through holes in double-sided printed wiring boards or via holes in multilayer printed wiring boards, and in addition, a wiring pattern of a metal is formed if necessary. In rough penetration, the transparent heat-resistant laminated film may be bonded to the inorganic substrate after a through electrode is formed as described above. In some cases, a through electrode may be fabricated after the inorganic substrate and the transparent heat-resistant laminated film are bonded together. It is also possible to penetrate the transparent heat-resistant laminated film and metallize the penetrated portion, but it is also possible to metallize the penetrated portion in a state where a hole is formed on one side of the transparent heat-resistant laminated film but does not penetrate the surface on the other side.

In the method for manufacturing a flexible electronic device in the present specification, a device is formed on the transparent heat-resistant laminated film of the laminate fabricated by the above-described method and then the transparent heat-resistant laminated film is peeled off from the inorganic substrate.

<Peeling off of transparent heat-resistant laminated film with device from inorganic substrate>

The method for peeling off the transparent heat-resistant laminated film with device from the inorganic substrate

is not particularly limited, but a method in which the transparent heat-resistant laminated film with device is stripped off from the end with tweezers and the like, a method in which a cut is made in the transparent heat-resistant laminated film, a pressure sensitive adhesive tape is pasted to one side of the cut portion, and then the transparent heat-resistant laminated film is stripped off from the tape portion, a method in which one side of the cut portion of the transparent heat-resistant laminated film is vacuum-adsorbed and then the transparent heat-resistant laminated film is stripped off from that portion, and the like can be employed. When the cut portion of the transparent heat-resistant laminated film is bent with a small curvature at the time of peeling off, stress may be applied to the device at that portion and the device may be destroyed, and it is thus desirable to peel off the transparent heat-resistant laminated film in a state of having a curvature as large as possible. For example, it is desirable to strip off the polymer film while winding the polymer film on a roll having a large curvature or to strip off the polymer film using a machine having a configuration in which the roll having a large curvature is located at the peeling portion.

As the method for making a cut in the transparent heat-resistant laminated film, there are a method in which the transparent heat-resistant laminated film is cut using a cutting tool such as a cutter, a method in which the transparent heat-resistant laminated film is cut by scanning a laser and the laminate relative to each other, a method in which the transparent heat-resistant laminated film is cut by scanning a water jet and the laminate relative to each other, a method in which the transparent heat-resistant laminated film is cut while being cut a little to the glass layer using a dicing apparatus for semiconductor chips, and the like, but the method is not particularly limited. For example, when the above-described methods are adopted, it is also possible to appropriately adopt a method in which ultrasonic waves are superimposed on the cutting tool or a reciprocating motion, a vertical motion and the like are further added to improve the cutting performance.

It is also useful to stick another reinforcing base material to the portion to be peeled off in advance and peel off the polymer film together with the reinforcing base material. In a case where the flexible electronic device to be peeled off is the backplane of a display device, it is also possible to obtain a flexible display device by pasting the front plane of the display device in advance, integrating these on an inorganic substrate, and then peeling off these two at the same time.

EXAMPLES

Hereinafter, the present invention will be described in detail with reference to Examples, but the present invention is not limited to the following Examples as long as the gist of the present invention is not exceeded.

[Production Example 1 (Production of polyimide solution 1 (PI-1))]

While nitrogen gas was introduced into a reaction vessel equipped with a nitrogen introducing tube, a Dean-Stark tube and a reflux tube, a thermometer, and a stirring bar, 19.86 parts by mass of 4,4'-diaminodiphenyl sulfone (4,4'-DDS), 4.97 parts by mass of 3,3'-diaminodiphenyl sulfone (3,3'-DDS), and 80 parts by mass of N,N-dimethylacetamide (DMAc) were added. Subsequently, 31.02 parts by mass of 4,4'-oxydiphthalic dianhydride (ODPA), 24 parts by mass of GBL, and 13 parts by mass of toluene were added at room temperature, then the temperature was raised to an internal temperature of 160°C, and the mixture was heated under reflux at 160°C for 1 hour for imidization. After the imidization was completed, the temperature was raised to 180°C, and the reaction was continuously conducted while extracting toluene. After the reaction for 12 hours, the oil bath was removed and the temperature was returned to room temperature, and DMAc was added so that the solid concentration was 20% by mass, thereby obtaining a polyimide solution 1 having a reduced viscosity of 0.70 dl/g.

[Production Example 2 (Production of polyamic acid solution 1 (PAA-1))]

The interior of a reaction vessel equipped with a nitrogen introducing tube, a reflux tube, and a stirring bar was purged with nitrogen, and then 33.36 parts by mass of 2,2'-ditrifluoromethyl-4,4'-diaminobiphenyl (TFMB), 336.31 parts by mass of N-methyl-2-pyrrolidone (NMP), and a dispersion obtained by dispersing colloidal silica as a lubricant in dimethylacetamide ("SNOWTEX (registered trademark) DMAC-ST-ZL" manufactured by Nissan Chemical Corporation) were added so that silica (lubricant) was 0.3% by mass of the total amount of polymer solids in the polyamic acid solution, and completely dissolved. Subsequently, 9.81 parts by mass of 1,2,3,4-cyclobutanetetracarboxylic dianhydride (CBDA), 11.34 parts by mass of 3,3',4,4'-biphenyltetracarboxylic dianhydride (BPDA), and 4.85 parts by mass of 4,4'-oxydiphthalic dianhydride (ODPA) were each added dividedly in the solid form, and the mixture was stirred at room temperature for 24 hours. Thereafter, a polyamic acid solution 1 having a solid content of 15% by mass and a reduced viscosity of 3.50 dl/g was obtained (molar ratio of TFMB//CBDA/BPDA/ODPA = 1.000//0.480/0.370/0.150).

[Production Example 3 (Production of polyamic acid solution 2 (PAA-2))]

The interior of a reaction vessel equipped with a nitrogen introducing tube, a reflux tube, and a stirring bar was purged with nitrogen, and then 336.31 parts by mass of N-methyl-2-pyrrolidone (NMP) was added to 33.36 parts by mass of 2,2'-ditrifluoromethyl-4,4'-diaminobiphenyl (TFMB) and completely dissolved. Subsequently, 9.81 parts by mass of 1,2,3,4-cyclobutanetetracarboxylic dianhydride (CBDA), 11.34 parts by mass of 3,3',4,4'-biphenyltetracarboxylic dianhydride (BPDA), and 4.85 parts by mass of 4,4'-oxydiphthalic dianhydride (ODPA) were each added dividedly in the solid form, and the mixture was stirred at room temperature for 24 hours. Thereafter, a polyamic acid solution 2 having a solid content of 15% by mass and a reduced viscosity of 3.50 dl/g was obtained (molar ratio of TFMB//CBDA/BPDA/ODPA = 1.000//0.480/0.370/0.150).

[Production Example 4 (Production of polyamic acid solution 3 (PAA-3))]

The interior of a reaction vessel equipped with a nitrogen introducing tube, a reflux tube, and a stirring bar was purged with nitrogen, and then 22.0 parts by mass of 2,2'-ditrifluoromethyl-4,4'-diaminobiphenyl (TFMB), 252.1 parts by mass of N,N-dimethylacetamide (DMAc), and a dispersion obtained by dispersing colloidal silica as a lubricant in dimethylacetamide ("SNOWTEX (registered trademark) DMAC-ST-ZL" manufactured by Nissan Chemical Corporation) were added so that silica (lubricant) was 0.3% by mass of the total amount of polymer solids in the polyamic acid solution, and completely dissolved. Subsequently, 22.0 parts by mass of 3,3',4,4'-biphenyltetracarboxylic dianhydride (BPDA) was added dividedly in the solid form, and the mixture was stirred at room temperature for 24 hours. Thereafter, 165.7 parts by mass of DMAc was added for dilution, thereby obtaining a polyamic acid solution 3 having a solid content (NV) of 11% by mass and a reduced viscosity of 3.5 dl/g (molar ratio of TFMB/BPDA = 0.920/1.000).

[Production Example 5 (Production of polyamic acid solution 4 (PAA-4))]

The interior of a reaction vessel equipped with a nitrogen introducing tube, a reflux tube, and a stirring bar was purged with nitrogen, and then 252.1 parts by mass of N,N-dimethylacetamide (DMAc) was added to 22.0 parts by mass of 2,2'-ditrifluoromethyl-4,4'-diaminobiphenyl (TFMB) and completely dissolved. Subsequently, 22.0 parts by mass of 3,3',4,4'-biphenyltetracarboxylic dianhydride (BPDA) was added dividedly in the solid form, and the mixture was stirred at room temperature for 24 hours. Thereafter, 165.7 parts by mass of DMAc was added for dilution, thereby obtaining a polyamic acid solution 4 having a solid content (NV) of 11% by mass and a reduced viscosity of 3.5 dl/g (molar ratio of TFMB/BPDA = 0.920/1.000).

[Production Example 6 (Production of polyamic acid solution 5 (PAA-5))]

The interior of a reaction vessel equipped with a nitrogen introducing tube, a reflux tube, and a stirring bar was purged with nitrogen, and then 22.73 parts by mass of 4,4'-diaminobenzanilide (DABAN), 201.1 parts by mass of N,N-dimethylacetamide (DMAc), and a dispersion obtained by dispersing colloidal silica as a lubricant in dimethylacetamide ("SNOWTEX (registered trademark) DMAC-ST-ZL" manufactured by Nissan Chemical Corporation) were added so that silica (lubricant) was 0.5% by mass of the total amount of polymer solids in the polyamic acid solution, and completely dissolved. Subsequently, 19.32 parts by mass of 1,2,3,4-cyclobutanetetracarboxylic dianhydride (CBDA) was added dividedly in the solid form, and the mixture was stirred at room temperature for 24 hours. Thereafter, 173.1 parts by mass of DMAc was added for dilution, thereby obtaining a polyamic acid solution 5 having NV (solid content) of 10% by mass and a reduced viscosity of 3.10 dl/g (molar ratio of DABAN/CBDA = 1.000/0.985).

[Production Example 7 (Production of polyamic acid solution 6 (PAA-6))]

The interior of a reaction vessel equipped with a nitrogen introducing tube, a reflux tube, and a stirring bar was purged with nitrogen, and then 201.1 parts by mass of N,N-dimethylacetamide (DMAc) was added to 22.73 parts by mass of 4,4'-diaminobenzanilide (DABAN) and completely dissolved. Subsequently, 19.32 parts by mass of 1,2,3,4-cyclobutanetetracarboxylic dianhydride (CBDA) was added dividedly in the solid form, and the mixture was stirred at room temperature for 24 hours. Thereafter, 173.1 parts by mass of DMAc was added for dilution, thereby obtaining a polyamic acid solution 6 having NV (solid content) of 10% by mass and a reduced viscosity of 3.10 dl/g (molar ratio of DABAN/CBDA = 1.000/0.985).

[Production Example 8 (Production of polyamic acid solution 7 (PAA-7))]

An acid anhydride group-containing double-decker silsesquioxane derivative (AASQ1) having the structure

represented by Formula (1) was procured from manufactured by Japan Material Technologies Corporation.

[Formula 1]

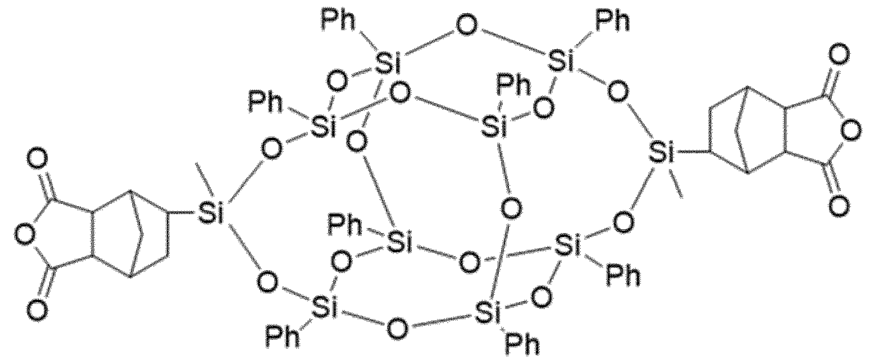

(1)

Next, the interior of a reaction vessel equipped with a nitrogen introducing tube, a reflux tube, and a stirring bar was purged with nitrogen, and then 490.2 parts by mass of 2,2'-ditrifluoromethyl-4,4'-diaminobiphenyl (TFMB), 5340 parts by mass of N-methyl-2-pyrrolidone (NMP), and a dispersion obtained by dispersing colloidal silica as a lubricant in dimethylacetamide ("SNOWTEX (registered trademark) DMAC-ST-ZL" manufactured by Nissan Chemical Corporation) were added so that silica (lubricant) was 0.3% by mass of the total amount of polymer solids in the polyamic acid solution, and completely dissolved. Subsequently, 327.2 parts by mass of pyromellitic dianhydride (PMDA) and 45.4 parts by mass of AASQ1 were each added dividedly in the solid form, and then the mixture was stirred at room temperature for 24 hours. Thereafter, a polyamic acid solution 7 having a solid content of 14% by mass and a reduced viscosity of 1.46 dl/g was obtained (molar ratio of TFMB//PMDA/AASQ1 = 1.000//0.980/0.020).

[Production Example 9 (Production of polyamic acid solution 8 (PAA-8))]

The interior of a reaction vessel equipped with a nitrogen introducing tube, a reflux tube, and a stirring bar was purged with nitrogen, and then 490.2 parts by mass of 2,2'-ditrifluoromethyl-4,4'-diaminobiphenyl (TFMB) and 5340 parts by mass of N-methyl-2-pyrrolidone (NMP) were added and completely dissolved. Subsequently, 327.2 parts by mass of pyromellitic dianhydride (PMDA) and 45.4 parts by mass of AASQ1 were each added dividedly in the solid form, and then the mixture was stirred at room temperature for 24 hours. Thereafter, a polyamic acid solution 8 having a solid content of 14% by mass and a reduced viscosity of 1.46 dl/g was obtained (molar ratio of TFMB//PMDA/AASQ1 = 1.000//0.980/0.020).

[Production Example 10 (Production of polyamic acid solution 9 (PAA-9))]

An amino group-containing double-decker silsesquioxane derivative (AMSQ1) having the structure represented by Formula (2) was produced by the method described in JP-A-2006-265243.

[Formula 2]

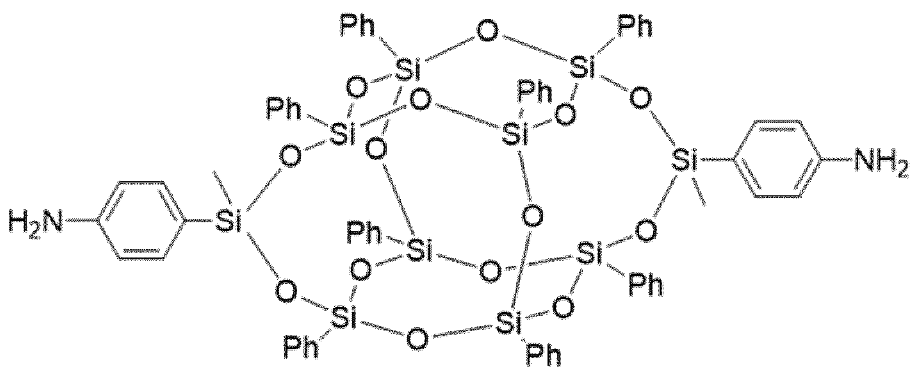

(2)

Next, the interior of a reaction vessel equipped with a nitrogen introducing tube, a reflux tube, and a stirring bar was purged with nitrogen, and then 470.8 parts by mass of 2,2'-ditrifluoromethyl-4,4'-diaminobiphenyl (TFMB), 39.9 parts by mass of AMSQ1, 6880 parts by mass of N-methyl-2-pyrrolidone (NMP), and a dispersion obtained by dispersing colloidal silica as a lubricant in dimethylacetamide ("SNOWTEX (registered trademark) DMAC-ST-ZL" manufactured by Nissan Chemical Corporation) were added so that silica (lubricant) was 0.3% by mass of the total amount of polymer solids in the polyamic acid solution, and completely dissolved. Subsequently, 325.6 parts by mass of pyromellitic dianhydride (PMDA) was added dividedly in the solid form, and then the mixture was stirred at room temperature for 24 hours. Thereafter, a polyamic acid solution 7 having a solid content of 11% by mass and a reduced viscosity of 3.50 dl/g was obtained (molar ratio of TFMB/AMSQ1//PMDA = 0.980/0.020//1.000).

[Production Example 11 (Production of polyamic acid solution 10 (PAA-10))]

The interior of a reaction vessel equipped with a nitrogen introducing tube, a reflux tube, and a stirring bar was purged with nitrogen, and then 470.8 parts by mass of 2,2'-ditrifluoromethyl-4,4'-diaminobiphenyl (TFMB), 39.9 parts by mass of AMSQ1, and 6880 parts by mass of N-methyl-2-pyrrolidone (NMP) were added and completely dissolved. Subsequently, 325.6 parts by mass of pyromellitic dianhydride (PMDA) was added dividedly in the solid form, and then the mixture was stirred at room temperature for 24 hours. Thereafter, a polyamic acid solution 7 having a solid content of 11% by mass and a reduced viscosity of 3.50 dl/g was obtained (molar ratio of TFMB/AMSQ1//PMDA = 0.980/0.020//1.000).

[Production Example 12 (Production of polyamic acid solution 11 (PAA-11))]

The interior of a reaction vessel equipped with a nitrogen introducing tube, a reflux tube, and a stirring bar was purged with nitrogen, and then 470.8 parts by mass of 2,2'-ditrifluoromethyl-4,4'-diaminobiphenyl (TFMB), 6766 parts by mass of N-methyl-2-pyrrolidone (NMP), and a dispersion obtained by dispersing colloidal silica as a lubricant in dimethylacetamide ("SNOWTEX (registered trademark) DMAC-ST-ZL" manufactured by Nissan Chemical Corporation) were added so that silica (lubricant) was 0.3% by mass of the total amount of polymer solids in the polyamic acid solution, and completely dissolved. Subsequently, 192.4 parts by mass of pyromellitic dianhydride (PMDA) and 173.0 parts by mass of 3,3',4,4'-biphenyltetracarboxylic dianhydride (BPDA) were each added dividedly in the solid form, and the mixture was stirred at room temperature for 24 hours. Thereafter, a polyamic acid solution 11 having a solid content of 11% by mass and a reduced viscosity of 3.50 dl/g was obtained (molar ratio of TFMB//PMDA/BPDA = 1.000//0.600/0.400).

[Production Example 13 (Production of polyamic acid solution 12 (PAA-12))]

The interior of a reaction vessel equipped with a nitrogen introducing tube, a reflux tube, and a stirring bar was purged with nitrogen, and then 470.8 parts by mass of 2,2'-ditrifluoromethyl-4,4'-diaminobiphenyl (TFMB), 39.9 parts by mass of AMSQ1, and 6766 parts by mass of N-methyl-2-pyrrolidone (NMP) were added and completely dissolved. Subsequently, 192.4 parts by mass of pyromellitic dianhydride (PMDA) and 173.0 parts by mass of 3,3',4,4'-biphenyltetracarboxylic dianhydride (BPDA) were each added dividedly in the solid form, and the mixture was stirred at room temperature for 24 hours. Thereafter, a polyamic acid solution 12 having a solid content of 11% by mass and a reduced viscosity of 3.50 dl/g was obtained (molar ratio of TFMB//PMDA/BPDA = 1.000//0.600/0.400).

[Example 1] (Fabrication of polyimide film A1)

The polyamic acid solution 1 (PAA-1) obtained in Production Example 2 was applied onto the lubricant-free surface of polyethylene terephthalate film A4100 (manufactured by TOYOBO CO., LTD.) using a comma coater so that the final film thickness was 1.5 um. Subsequently, the polyamic acid solution 2 (PAA-2) obtained in Production Example 3 was applied onto the polyamic acid solution 1 (PAA-1) using a die coater so that the final film thickness was 22 um. After 60 seconds, this was introduced into a hot air furnace and dried at 110°C for 10 minutes. The polyamic acid film that gained self-supporting properties after drying was peeled off from the A4100 film that had served as a support, allowed to pass through a pin tenter with a pin sheet having pins disposed, and gripped by inserting the film edges into the pins, the pin sheet interval was adjusted so that the film did not break and unnecessary slackening did not occur, and the film was transported and heated at 200°C for 3 minutes, at 250°C for 3 minutes, at 300°C for 3 minutes, and at 400°C for 3 minutes to conduct the imidization reaction. Thereafter, the film was cooled to room temperature for 2 minutes, the portions exhibiting poor flatness at both ends of the film were cut off using a slitter, and the film was wound into a roll shape, thereby obtaining a polyimide film A1 having a width of 450 mm by 500 m.

[Example 2] (Fabrication of polyimide film A2)

The polyamic acid solution 1 (PAA-1) obtained in Production Example 2 was applied onto the lubricant-free surface of polyethylene terephthalate film A4100 (manufactured by TOYOBO CO., LTD.) using a comma coater so that the final film thickness was 1.5 um. Subsequently, the polyimide solution 1 (PI-1) obtained in Production Example 1 was applied onto the polyamic acid solution 1 (PAA-1) using a die coater so that the final film thickness was 22 um. After 60 seconds, this was introduced into a hot air furnace and dried at 110°C for 10 minutes. The polyamic acid film that gained self-supporting properties after drying was peeled off from the A4100 film that had served as a support, allowed to pass through a pin tenter with a pin sheet having pins disposed, and gripped by inserting the film edges into the pins, the pin sheet interval was adjusted so that the film did not break and unnecessary slackening did not occur, and the film was transported and heated at 200°C for 3 minutes, at 250°C for 3 minutes, and at 300°C for 6 minutes to conduct the imidization reaction. Thereafter, the film was cooled to room temperature for 2 minutes, the portions exhibiting poor flatness at both edges of the film were cut off using a slitter, and the film was wound into a roll shape, thereby obtaining a polyimide film A2 having a width of 450 mm by 500 m.

[Example 3] (Fabrication of polyimide film A3)

The polyamic acid solution 5 (PAA-5) obtained in Production Example 6 was applied onto the lubricant-free surface of polyethylene terephthalate film A4100 (manufactured by TOYOBO CO., LTD.) using a comma coater so that the final film thickness was 1.5 um. Subsequently, the polyimide solution 1 (PI-1) obtained in Production Example 1 was applied onto the polyamic acid solution 5 (PAA-5) using a die coater so that the final film thickness was 22 um. After 60 seconds, this was introduced into a hot air furnace and dried at 110°C for 10 minutes. The polyamic acid film that gained self-supporting properties after drying was peeled off from the A4100 film that had served as a support, allowed to pass through a pin tenter with a pin sheet having pins disposed, and gripped by inserting the film edges into the pins, the pin sheet interval was adjusted so that the film did not break and unnecessary slackening did not occur, and the film was transported and heated at 200°C for 3 minutes, at 250°C for 3 minutes, at 300°C for 3 minutes, and at 375°C for 3 minutes to conduct the imidization reaction. Thereafter, the film was cooled to room temperature for 2 minutes, the portions exhibiting poor flatness at both edges of the film were cut off using a slitter, and the film was wound into a roll shape, thereby obtaining a polyimide film A3 having a width of 450 mm by 500 m.

[Example 4] (Fabrication of polyimide film A4)

A polyimide film A4 was obtained in the same manner as in Example 3 except that the polyimide solution 1 (PI-1) was changed to the polyamic acid solution 2 (PAA-2).

[Example 5] (Fabrication of polyimide film A5)

A polyimide film A5 was obtained in the same manner as in Example 2 except that the polyamic acid solution 1 (PAA-1) was changed to the polyamic acid solution 5 (PAA-5) and the polyimide solution 1 (PI-1) was changed to the polyamic acid solution 4 (PAA-4).

[Example 6] (Fabrication of polyimide film A6)

A polyimide film A6 was obtained in the same manner as in Example 2 except that the polyamic acid solution 1 (PAA-1) was changed to the polyamic acid solution 3 (PAA-3) and the polyimide solution 1 (PI-1) was changed to the polyamic acid solution 4 (PAA-4).

[Example 7] (Fabrication of polyimide film A7)

A polyimide film A7 was obtained in the same manner as in Example 3 except that the polyamic acid solution 5 (PAA-5) was changed to the polyamic acid solution 7 (PAA-7) and the polyimide solution 1 (PI-1) was changed to the polyamic acid solution 8 (PAA-8).

[Example 8] (Fabrication of polyimide film A8)

A polyimide film A8 was obtained in the same manner as in Example 1 except that the polyamic acid solution 1 (PAA-1) was changed to the polyamic acid solution 9 (PAA-9) and the polyamic acid solution 2 (PAA-2) was changed to the polyamic acid solution 1 (PAA-10).

[Example 9] (Fabrication of polyimide film A14)

A polyimide film A14 was obtained in the same manner as in Example 1 except that the polyamic acid solution 1 (PAA-1) was changed to the polyamic acid solution 11 (PAA-11), the polyamic acid solution 2 (PAA-2) was changed to the polyamic acid solution 12 (PAA-12), and the heating conditions were changed to heating at 200°C for 15 minutes, at 250°C for 15 minutes, at 300°C for 15 minutes, and at 400°C for 15 minutes.

[Comparative Example 1] (Fabrication of polyimide film A9)

The polyamic acid solution 6 (PAA-6) obtained in Production Example 7 was applied onto the lubricant-free surface of polyethylene terephthalate film A4100 (manufactured by TOYOBO CO., LTD.) using a comma coater so that the final film thickness was 3 μm. The polyethylene terephthalate film A4100 was allowed to pass through a hot air furnace, wound up, and dried at 100°C for 10 minutes at this time. This was wound up and then set again on the comma coater side, and the polyamic acid solution 2 (PAA-2) obtained in Production Example 3 was applied onto the dried polyamic acid solution 6 (PAA-6) so that the final film thickness was 20 um. This was dried at 100°C for 10 minutes. The polyamic acid film that gained self-supporting properties after drying was peeled off from the support, allowed to pass through a pin tenter with a pin sheet having pins disposed, and gripped by inserting the film ends into the pins, the pin sheet interval was adjusted so that the film did not break and unnecessary slackening did not occur, and the film was transported and heated at 200°C for 3 minutes, at 250°C for 3 minutes, at 300°C for 3 minutes, and at 370°C for 3 minutes to conduct the imidization reaction. Thereafter, the film was cooled to room temperature for 2 minutes, the portions exhibiting poor flatness at both edges of the film were cut off using a slitter, and the film was wound into a roll shape, thereby obtaining a polyimide film A9 having a width of 450 mm by 30 m. A film was obtained, but wrinkled when wound into a roll shape.

[Comparative Example 2] (Fabrication of polyimide film A10)

The polyamic acid solution 6 (PAA-6) obtained in Production Example 7 was applied onto the lubricant-free surface of polyethylene terephthalate film A4100 (manufactured by TOYOBO CO., LTD.) using a comma coater so that the final film thickness was 3 um. The polyethylene terephthalate film A4100 was allowed to pass through a hot air furnace, wound up, and dried at 100°C for 10 minutes at this time. This was wound up and then set again on the comma coater side, and the polyimide solution 1 (PI-1) obtained in Production Example 1 was applied onto the dried polyamic acid solution 6 (PAA-6) so that the final film thickness was 20 um. This was dried at 100°C for 10 minutes. The polyamic acid film that gained self-supporting properties after drying was peeled off from the support, allowed to pass through a pin tenter with a pin sheet having pins disposed, and gripped by inserting the film edges into the pins, the pin sheet interval was adjusted so that the film did not break and unnecessary slackening did not occur, and the film was transported and heated at 200°C for 3 minutes, at 250°C for 3 minutes, and at 300°C for 6 minutes to conduct the imidization reaction. Thereafter, the film was cooled to room temperature for 2 minutes, the portions exhibiting poor flatness at both edges of the film were cut off using a slitter, and the film was wound into a roll shape, thereby obtaining a polyimide film A10 having a width of 450 mm by 20 m. A film was obtained, but wrinkled when wound into a roll shape.

[Comparative Example 3] (Fabrication of polyimide film A11)

A polyimide film A11 was obtained by 300 m in the same manner as in Comparative Example 1 except that the polyamic acid solution 5 (PAA-5) was used instead of the polyamic acid solution 6 (PAA-6).

[Comparative Example 4] (Fabrication of polyimide film A12)

The polyamic acid solution 3 (PAA-3) obtained in Production Example 4 was applied onto the lubricant-free surface of polyethylene terephthalate film A4100 (manufactured by TOYOBO CO., LTD.) using a comma coater so that the final film thickness was 1.5 um. The polyethylene terephthalate film A4100 was allowed to pass through a hot air furnace, wound up, and dried at 100°C for 10 minutes at this time. This was wound up and then set again on the comma coater side, and the polyamic acid solution 1 (PAA-1) obtained in Production Example 3 was applied onto the dried polyamic acid solution 3 (PAA-3) so that the final film thickness was 20 um. This was dried at 100°C for 10 minutes. The polyamic acid film that gained self-supporting properties after drying was peeled off from the support, allowed to pass through a pin tenter with a pin sheet having pins disposed, and gripped by inserting the film ends into the pins, the pin sheet interval was adjusted so that the film did not break and unnecessary slackening did not occur, and the film was transported and heated at 200°C for 3 minutes, at 250°C for 3 minutes, at 300°C for 3 minutes, and at 400°C for 3 minutes to conduct the imidization reaction. Thereafter, the film was cooled to room temperature for 2 minutes, the

portions exhibiting poor flatness at both edges of the film were cut off using a slitter, and the film was wound into a roll shape, thereby obtaining a polyimide film A12 having a width of 450 mm by 200 m.

[Comparative Example 5] (Fabrication of polyimide film A13)

A polyimide film A13 having a width of 450 mm was obtained by 20 m in the same manner as in Example 2 except that the polyamic acid solution 4 (PAA-4) was used instead of the polyamic acid solution 1 (PAA-1) and the polyamic acid solution 2 (PAA-2) was used instead of the polyimide solution 1 (PI-1). A film was obtained, but wrinkled when wound into a roll shape.

<Thickness measurement of transparent heat-resistant laminated film (polyimide film)>

The thickness of the polyimide films A1 to A11 was measured using a micrometer (Millitron 1245D manufactured by Feinpruf GmbH). The results are presented in Table 1.

<Tensile modulus, tensile strength at break, and tensile elongation at break of transparent heat-resistant laminated film (polyimide film)>

The polyimide films A1 to A14 were cut into a strip shape of 100 mm × 10 mm in the machine direction (MD direction) and the transverse direction (TD direction) respectively to be used as test pieces. The tensile modulus, tensile strength at break, and tensile elongation at break in each of the MD direction and the TD direction were measured at a tensile speed of 50 mm/min and a distance between chucks of 40 mm using a tensile tester (Autograph (R), Model name: AG-5000A manufactured by Shimadzu Corporation).

<Coefficient of linear thermal expansion (CTE) of transparent heat-resistant laminated film (polyimide film)>

The expansion/contraction rate of the polyimide films A1 to A14 in the machine direction (MD direction) and the transverse direction (TD direction) was measured under the following conditions, the expansion/contraction rate/temperature was measured at intervals of 15°C, such as 30°C to 45°C and 45°C to 60°C, this measurement was performed up to 300°C, and the average value of all measured values was calculated as CTE.

Instrument name; TMA4000S manufactured by MAC Science Corporation
Length of sample; 20 mm
Width of sample; 2 mm
Start temperature in temperature increase; 25°C
End temperature in temperature increase; 300°C
Rate of temperature increase; 5°C/min
Atmosphere; Argon

<Out of plane retardation (Rth) of transparent heat-resistant laminated film (polyimide film)>

The refractive index nx in the X-axis direction, the refractive index ny in the Y-axis direction, and the refractive index nz in the Z-axis direction of the polyimide films A1 to A14 were measured with light having a wavelength of 550 nm at room temperature (20°C to 25°C) using an optical material inspection system (Model RETS-100) manufactured by Otsuka Electronics Co., Ltd.. The optical axis was detected and the phase advance and phase delay were corrected, and then the retardation measurement method was measured by the rotating analyzer method. Here, the X-axis and the Y-axis indicate the refractive index (nx) in the direction having the largest refractive index in the plane direction of the film and the refractive index (ny) in the direction perpendicular to the Nx direction in the plane direction of the film. Then, Rth was calculated from the refractive index nx in the X-axis direction, the refractive index ny in the Y-axis direction, the refractive index nz in the Z-axis direction, and the film thickness (d) based on the following equation.

$$Rth\ (nm) = |[nz - (nx + ny)/2] \times d|$$

<Heat shrinkage of transparent heat-resistant laminated film (polyimide film)>

The temperature was raised to 300°C and then lowered to 80°C when the coefficient of linear thermal expansion (CTE) of the polyimide film was measured, and the percentage of the ratio of the length at 100°C during the initial

temperature increase to the length at 100°C during the temperature decrease was calculated as the heat shrinkage rate.

<Measurement of intermingled layer>

For the intermingled layer, a diagonally cut surface of a polyimide film is fabricated using Model SAICAS DN-20S (DAIPLA WINTES CO., LTD.). Next, this diagonally cut surface was subjected to the measurement by a microscopic ATR method using a germanium crystal (incident angle: 30°) and microscopic IR Cary 620 FTIR (Agilent Technologies, Inc.). The measurement results thus acquired are presented in Table 1.

[Table 1]

| | | Example 1 | Example 2 | Example 3 | Example 4 | Example 5 | Example 6 | Example 7 | Example 8 | Example 9 | Comparative Example 1 | Comparative Example 2 | Comparative Example 3 | Comparative Example 4 | Comparative Example 5 |
|---|---|---|---|---|---|---|---|---|---|---|---|---|---|---|---|
| Film used | | A1 | A2 | A3 | A4 | A5 | A6 | A7 | A8 | A14 | A9 | A10 | A11 | A12 | A13 |
| Layer configuration | Composition of layer (a) | PAA-2 | PI-1 | PI-1 | PAA-2 | PAA-4 | PAA-4 | PAA-8 | PAA-10 | PAA-12 | PAA-2 | PI-1 | PI-1 | PAA-1 | PAA-2 |
| | Amount of lubricant added to layer (a) (% by mass) | 0 | 0 | 0 | 0 | 0 | 0 | 0 | 0 | 0 | 0 | 0 | 0 | 0.3 | 0 |
| | Composition of layer (b) | PAA-1 | PAA-1 | PAA-5 | PAA-5 | PAA-5 | PAA-3 | PAA-7 | PAA-9 | PAA-11 | PAA-6 | PAA-6 | PAA-5 | PAA-3 | PAA-4 |
| | Amount of lubricant added to layer (b) (% by mass) | 0.3 | 0.3 | 0.5 | 0.5 | 0.5 | 0.3 | 0.3 | 0.3 | 0.3 | 0 | 0 | 0.5 | 0.3 | 0 |
| Film thickness (μm) | | 22 | 22 | 22 | 22 | 22 | 22 | 22 | 22 | 22 | 20 | 20 | 20 | 20 | 20 |
| Intermingled layer thickness (μm) | | 8 | 5 | 6 | 5 | 6 | 7 | 8 | 6 | 7 | 1 | 0.5 | 0.8 | 0.7 | 7 |
| Long roll appearance | | Favorable | Favorable | Favorable | Favorable | Favorable | Favorable | Favorable | Favorable | Favorable | Poor | Poor | Favorable | Favorable | Poor |
| Film warping (μm) | | 200 | 360 | 500 | 450 | 350 | 210 | 200 | 200 | 200 | 3400 | 4500 | 4400 | 3200 | 400 |
| Tensile modulus (MD direction) (GPa) | | 4.6 | 3.5 | 3.8 | 4.8 | 3.8 | 3.5 | 8.9 | 6.7 | 7.4 | 4.8 | 3.8 | 3.8 | 4.2 | 4.3 |
| Tensile modulus (TD direction) (GPa) | | 4.7 | 3.6 | 3.8 | 4.9 | 3.9 | 3.7 | 9.1 | 6.9 | 7.6 | 4.9 | 3.7 | 3.7 | 4.3 | 4.1 |
| Tensile strength at break (MD direction) (MPa) | | 169 | 138 | 142 | 165 | 141 | 145 | 231 | 235 | 180 | 167 | 143 | 144 | 161 | 168 |
| Tensile strength at break (TD direction) (MPa) | | 198 | 140 | 145 | 189 | 145 | 149 | 238 | 239 | 182 | 188 | 146 | 147 | 175 | 179 |

(continued)

| | Example 1 | Example 2 | Example 3 | Example 4 | Example 5 | Example 6 | Example 7 | Example 8 | Example 9 | Comparative Example 1 | Comparative Example 2 | Comparative Example 3 | Comparative Example 4 | Comparative Example 5 |
|---|---|---|---|---|---|---|---|---|---|---|---|---|---|---|
| Film used | A1 | A2 | A3 | A4 | A5 | A6 | A7 | A8 | A14 | A9 | A10 | A11 | A12 | A13 |
| Tensile elongation at break (MD direction) (%) | 21 | 18 | 15 | 16 | 12 | 14 | 11 | 10 | 13 | 17 | 14 | 16 | 18 | 18 |
| Tensile elongation at break (TD direction) (%) | 27 | 19 | 14 | 18 | 14 | 15 | 12 | 11 | 15 | 16 | 15 | 15 | 19 | 20 |
| Coefficient of linear thermal expansion (MD direction) (ppm/°C) | 46 | 49 | 45 | 44 | 28 | 29 | 3 | 4 | 9 | 44 | 45 | 44 | 45 | 44 |
| Coefficient of linear thermal expansion (TD direction) (ppm/°C) | 41 | 47 | 43 | 40 | 26 | 28 | 2 | 3 | 7 | 42 | 44 | 43 | 44 | 46 |
| Out of plane retardation (nm) | 85 | 63 | 135 | 189 | 498 | 460 | 1623 | 1773 | 1901 | 183 | 142 | 172 | 135 | 139 |
| Haze (%) | 0.7 | 0.6 | 0.8 | 0.9 | 1.8 | 1.6 | 0.8 | 0.8 | 1.1 | 0.9 | 0.8 | 0.8 | 1.1 | 1.0 |
| Total light transmittance (%) | 89 | 88 | 87 | 86 | 85 | 86 | 85 | 85 | 87 | 86 | 87 | 87 | 87 | 87 |
| Yellow index | 3.2 | 2.9 | 4.2 | 4.8 | 4.1 | 4.0 | 17.0 | 14.1 | 8.2 | 4.7 | 4.3 | 4.4 | 3.8 | 3.8 |
| Kind of inorganic substrate | Glass | Glass | Glass | Glass | Glass | Glass | Glass | Glass | Glass | Glass | Glass | Glass | Glass | Glass |
| Surface of transparent heat-resistant laminated film bonded to inorganic substrate | Layer (b) | Layer (b) | Layer (b) | Layer (b) | Layer (b) | Layer (b) | Layer (b) | Layer (b) | Layer (b) | Layer (b) | Layer (b) | Layer (b) | Layer (b) | Layer (b) |
| Peel strength after heating at 300°C (N/cm) | 0.06 | 0.07 | 0.07 | 0.06 | 0.08 | 0.06 | 0.06 | 0.06 | 0.06 | 0.09 | 0.08 | 0.07 | 0.06 | 0.05 |

<Warping measurement of transparent heat-resistant laminated film (polyimide film)>

The polyimide films A1 to A14 cut into 30cm × 30cm were conditioned in an environment of 23°C and 50% for one day or more, and then placed on a surface plate to be subjected to the measurement of warping. The lifting of four corners of the film from the surface plate was measured. The average value of warping at the four corners was taken as the amount of warping of each film.

<Fabrication of laminate with inorganic substrate>

The method for coating a glass substrate with a silane coupling agent was carried out using an experimental apparatus illustrated in Fig. 1. Fig. 1 is a schematic diagram of an experimental apparatus for coating a glass substrate with a silane coupling agent. As the glass substrate, 0.7 mm thick OA11G glass cut into a size of 100 mm × 100 mm (manufactured by NEG Co., Ltd.) was used. The glass substrate used was washed with pure water, dried, and then irradiated using a UV/O3 irradiator (SKR1102N-03 manufactured by LANTECHNICAL SERVICE CO., LTD.) for 1 minute for dry cleaning. Into a chemical tank having a capacity of 1 L, 150 g of 3-aminopropyltrimethoxysilane (silane coupling agent, Shin-Etsu Chemical KBM903) was put, and the outer water bath of this chemical tank was warmed to 41°C. The vapor that came out was then sent to the chamber together with clean dry air. The gas flow rate was set to 25 L/min and the substrate temperature was set to 23°C. The temperature of clean dry air was 23°C and the humidity thereof was 1.2% RH. Since the exhaust is connected to the exhaust port having a negative pressure, it is confirmed that the chamber has a negative pressure of about 2 Pa by a differential pressure gauge. The silane coupling agent application time was set to 4 minutes.

Next, the polyimide film (A1 to A14, 70 mm × 70 mm in size) was bonded onto the silane coupling agent layer to obtain a laminate. At this time, the bonding surface is the layer (b) side. A laminator manufactured by MCK CO., LTD. was used for bonding, and the bonding conditions were set to compressed air pressure: 0.6 MPa, temperature: 22°C, humidity: 55% RH, and lamination speed: 50 mm/sec.

<Measurement of 90° peel strength after heating at 300°C for 1 hour>

The laminates obtained in the above-described fabrication of laminate were subjected to heat treatment at 100°C for 10 minutes in an air atmosphere (pretreatment). The laminates were further heated at 300°C for 1 hour in a nitrogen ambience. Thereafter, the 90° peel strength between the inorganic substrate and the polyimide film was measured. The results are presented in Table 1.

The measurement conditions for 90° initial peel strength are as follows.

The film is peeled off from the inorganic substrate at an angle of 90°.

The measurement is performed 5 times and the average value thereof is taken as the measured value.

Measuring instrument; Autograph AG-IS manufactured by Shimadzu Corporation
Measured temperature; Room temperature (25°C)
Peeling speed; 100 mm/min
Atmosphere; Air
Width of measured sample; 2.5 cm

<Haze of transparent heat-resistant laminated film (polyimide film)>

The haze of the polyimide film was measured using HAZEMETER (NDH5000 manufactured by NIPPON DENSHOKU INDUSTRIES CO., LTD.). A D65 lamp was used as the light source. The same measurement was performed 3 times and the arithmetic mean value thereof was adopted.

<Total light transmittance of transparent heat-resistant laminated film (polyimide film)>

The total light transmittance (TT) of the polyimide film was measured using HAZEMETER (NDH5000 manufactured by NIPPON DENSHOKU INDUSTRIES CO., LTD.). A D65 lamp was used as the light source. The same measurement was performed 3 times and the arithmetic mean value thereof was adopted.

<Color of transparent heat-resistant laminated film (polyimide film)>

The yellow index was measured. Using a color meter (ZE6000 manufactured by NIPPON DENSHOKU INDUSTRIES CO., LTD.) and a C2 light source, the tristimulus values, XYZ values of the polyimide film were measured in

conformity with ASTM D1925, and the yellow index (YI) was calculated by the following equation. The same measurement was performed 3 times and the arithmetic mean value thereof was adopted.

$$YI = 100 \times (1.28X - 1.06Z)/Y$$

DESCRIPTION OF REFERENCE SIGNS

1 Flow meter
2 Gas inlet
3 Chemical tank (silane coupling agent tank)
4 Hot water tank (water bath)
5 Heater
6 Processing chamber (chamber)
7 Base material
8 Exhaust port

## Claims

**1.** A transparent heat-resistant laminated film comprising a layer (a) and a layer (b), wherein

an intermingled layer is present at an interface between the layer (a) and the layer (b), and
a thickness of the intermingled layer is 3 μm or more,
layer (a): a layer that contains a polyimide composition
layer (b): a layer that contains a polyimide composition and has a higher inorganic filler content than the layer (a).

**2.** The transparent heat-resistant laminated film according to claim 1, wherein an inorganic filler content in the layer (a) is less than 0.03% by mass.

**3.** The transparent heat-resistant laminated film according to claim 1 or 2, wherein an inorganic filler content in the layer (b) is 0.03% by mass or more.

**4.** The transparent heat-resistant laminated film according to claim 1 or 2, wherein a thickness of the transparent heat-resistant laminated film is 5 μm or more and 200 um or less.

**5.** The transparent heat-resistant laminated film according to claim 1 or 2, wherein all layers, including the layer (a) and the layer (b), constituting the transparent heat-resistant laminated film contain a polyimide composition.

**6.** The transparent heat-resistant laminated film according to claim 1 or 2, wherein the transparent heat-resistant laminated film comprises only the layer (a), the intermingled layer, and the layer (b).

**7.** A laminate comprising the transparent heat-resistant laminated film according to claim 1 or 2 and an inorganic substrate, wherein
an adhesive is substantially not used and a peel strength between the inorganic substrate and the transparent heat-resistant laminated film after heating at 300°C is 0.3 N/cm or less.

**8.** A method for manufacturing a film with electronic device, the method comprising forming an electronic device on a transparent heat-resistant laminated film of the laminate according to claim 7 and then peeling off the electronic device-formed transparent heat-resistant laminated film from an inorganic substrate.

Fig.1

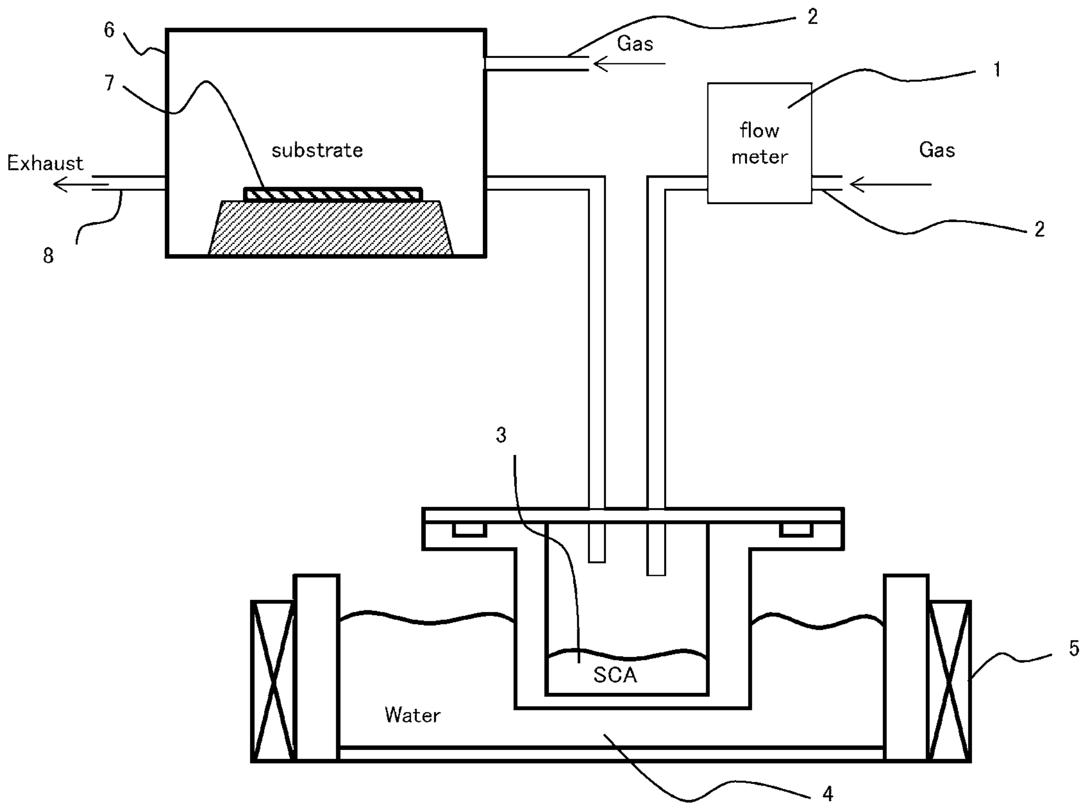

**INTERNATIONAL SEARCH REPORT**

International application No.
**PCT/JP2022/027904**

**A. CLASSIFICATION OF SUBJECT MATTER**

***B32B 27/20***(2006.01)i; ***B32B 27/34***(2006.01)i
FI: B32B27/34; B32B27/20 Z

According to International Patent Classification (IPC) or to both national classification and IPC

**B. FIELDS SEARCHED**

Minimum documentation searched (classification system followed by classification symbols)

B32B1/00-43/00; B05D1/00-7/26; H05K1/03

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2018/225825 A1 (NISSAN CHEMICAL CORP.) 13 December 2018 (2018-12-13) claims 1, 3-4, paragraphs [0009], [0070], [0075]-[0086], [0101], fig. 2-4 | 1-8 |
| A | WO 2016/117636 A1 (UNITIKA LTD.) 28 July 2016 (2016-07-28) whole document | 1-8 |
| A | JP 2016-120663 A (DU PONT-TORAY CO., LTD.) 07 July 2016 (2016-07-07) whole document | 1-8 |
| A | WO 2015/182419 A1 (KANEKA CORP.) 03 December 2015 (2015-12-03) whole document | 1-8 |
| A | JP 2-206542 A (HITACHI CHEM. CO., LTD.) 16 August 1990 (1990-08-16) whole document | 1-8 |
| A | WO 2013/191052 A1 (TOYOBO CO., LTD.) 27 December 2013 (2013-12-27) whole document | 1-8 |
| A | JP 3-21447 A (UBE IND., LTD.) 30 January 1991 (1991-01-30) whole document | 1-8 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **16 September 2022** | **04 October 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/027904**

| Patent document cited in search report | Publication date (day/month/year) | Patent family member(s) | Publication date (day/month/year) |
|---|---|---|---|
| WO 2018/225825 A1 | 13 December 2018 | KR 10-2020-0017433 A<br>claims 1, 3-4, paragraphs [0011], [0203]-[0209], [0216]-[0245], [0309]-[0311], fig. 2-4<br>CN 111344130 A<br>TW 201919912 A | |
| WO 2016/117636 A1 | 28 July 2016 | CN 107206755 A<br>whole document<br>KR 10-2017-0106316 A<br>TW 201634273 A | |
| JP 2016-120663 A | 07 July 2016 | (Family: none) | |
| WO 2015/182419 A1 | 03 December 2015 | US 2017/0190910 A1<br>whole document<br>KR 10-2017-0010380 A<br>CN 106471065 A<br>TW 201602185 A | |
| JP 2-206542 A | 16 August 1990 | (Family: none) | |
| WO 2013/191052 A1 | 27 December 2013 | US 2015/0125665 A1<br>whole document<br>EP 2865523 A1<br>CN 104395080 A<br>KR 10-2015-0023046 A<br>TW 201412551 A | |
| JP 3-21447 A | 30 January 1991 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011074384 A
- WO 2012118020 A
- JP 2006265243 A